# EUROPÄISCHE PATENTSCHRIFT

(11) **EP 1 869 705 B1**
(45) Veröffentlichungstag und Bekanntmachung des Hinweises auf die Patenterteilung: **11.12.2013**
(21) Anmeldenummer: 06724182.8
(22) Anmeldetag: 10.04.2006
(51) Int. Cl.: B81C 1/00, H01L 27/146, H01L 31/0203, H01L 23/08, H01L 31/0232

(54) **VERFAHREN ZUR HERSTELLUNG GEHÄUSTER ELEKTRONISCHER BAUELEMENTE UND GEHÄUSTES ELEKTRONISCHES BAUELEMENT**
METHOD FOR MANUFACTURING ENCLOSED ELECTRONIC DEVICES AND ENCLOSED ELECTRONIC DEVICE
PROCÉDÉ DE FABRICATION DE DISPOSITIFS ÉLECTRONIQUES EN BOÎTIER ET DISPOSITIF ÉLECTRONIQUE EN BOÎTIER

(30) Priorität: 11.04.2005 DE 102005016751
(43) Veröffentlichungstag der Anmeldung: 26.12.2007
(73) Patentinhaber: Schott AG, 55122 Mainz (DE)
(72) Erfinder: LEIB, Jürgen, 85354 Freising (DE); MUND, Dietrich, 84101 Obersüßbach (DE)
(74) Vertreter: Herden, Andreas F.
(86) Internationale Anmeldenummer: PCT/EP2006/003247
(87) Internationale Veröffentlichungsnummer: WO 2006/108588

(56) Entgegenhaltungen:
- EP-A- 1 445 803
- EP-A- 1 503 420
- US-A1- 2002 113 296
- US-A1- 2004 029 360
- MUND D ET AL: "Novel microstructuring technology for glass on silicon and glass-substrates" ELECTRONIC COMPONENTS AND TECHNOLOGY, 2004. ECTC '04. PROCEEDINGS LAS VEGAS, NV, USA JUNE 1-4, 2004, PISCATAWAY, NJ, USA,IEEE, Bd. 1, 1. Juni 2004 (2004-06-01), Seiten 939-942, XP010714654 ISBN: 0-7803-8365-6
- LEIB J ET AL: "New wafer-level-packaging technology using silicon-via-contacts for optical and other sensor applications" ELECTRONIC COMPONENTS AND TECHNOLOGY, 2004. ECTC '04. PROCEEDINGS LAS VEGAS, NV, USA JUNE 1-4, 2004, PISCATAWAY, NJ, USA,IEEE, Bd. 1, 1. Juni 2004 (2004-06-01), Seiten 843-847, XP010714585 ISBN: 0-7803-8365-6

## Beschreibung

### Beschreibung der Erfindung:

Die Erfindung betrifft ein Verfahren zur Herstellung gehäuster, elektronischer, insbesondere optoelektronischer Bauelemente im Waferverbund und gehäuste, elektronische, insbesondere opto-elektronische Bauelemente.

### Hintergrund der Erfindung:

Für die Fertigung von integrierten elektronischen, opto-elektronischen oder anderen Bauelementen für Mikrosysteme wurden Technologien entwickelt, die eine Erzeugung genau strukturierter Verkapselungs- bzw. Passivierungsschichten und/oder -hohlräume (Kavitäten) ermöglicht. Die Gehäusung von opto-elektronischen Bauelementen, welche einen optischen Sensor oder optisch aktive Elemente aufweisen, erfolgt mit lichtdurchlässigen Abdeckungen, welche die lichtempfindlichen Elemente vor Umgebungseinflüssen, wie beispielsweise Feuchtigkeit oder etwa vor mechanischen Beschädigungen schützen.

Dabei wird Glas für eine Vielzahl von Anwendungen eingesetzt, unter anderem wegen dessen optischen Eigenschaften und hervorragenden Passivierungseigenschaften. Gegenüber den für die Verpackung und Kapselung von Halbleiterbauelementen häufig eingesetzten Kunststoffen besitzen Gläser beispielsweise eine deutlich geringe Permeabilität für Luft und bieten darüber hinaus auch einen hervorragenden Schutz gegen Wasser, Wasserdampf und insbesondere auch gegen aggressive Stoffe, wie Säuren und Basen.

Derart gehäuste Mikro-Bauelemente werden typischerweise im Zusammenhang mit zum Beispiel Fingerprintsensoren, MEMS-Bauteilen, CCD-Kameras und Scannern eingesetzt. D. h. diese Verfahren eignen sich insbesondere zum Packaging von Bauelementen, die einen sensitiven Bereich, z. B. einen optischen Sensor, aufweisen, der durch ein Gehäuse geschützt werden muß, wobei jedoch über das Gehäuse sicherzustellen ist, dass der Sensor seine externe, z. B. optische, Zugänglichkeit behält.

Die Fertigung des Bauelements, die Gehäusung der Bauelemente und die Herstellung der Anschlusskontaktierung nach außen erfolgt entweder noch im Verbund eines Wafers (wafer-level-packaging) oder auf dem vereinzelten Bauelement bzw. Halbleiterchip (single-size-packaging).

Eine Gehäusung der Bauelemente bzw. Chips nach dem Vereinzeln hat jedoch den Nachteil, dass die integrierten Schaltungen und/oder sensitiven Bereiche der Bauelemente während der Vereinzelung offen liegen und deren Funktion durch den beim Zersägen (Dicen) der Wafer entstehenden Schmutz oder Staub beeinträchtigt werden.

Im Rahmen des wafer-level-packaging wird deshalb z. B. bei einer optisch aktiven Fläche eines Halbleiterbauelements der aktive Bereich durch das Aufkleben eines Glases oder einer Folie auf den Siliziumwafer geschützt.

Die fertig geschnittenen Bauelemente, sogenannte Die's, müssen jedoch nach dem Dicen, also dem Abtrennen der Die's vom Wafer, neu einjustiert und ausgerichtet werden, bevor die Gehäusung aufgesetzt werden kann, was zu zusätzlichen Fertigungsschritten führt und entsprechend die Produktion verlangsamt und verteuert.

Für die Herstellung von integrierten elektronischen und opto-elektronischen oder anderen Mikro-Bauelementen werden inzwischen vorrangig unterschiedlichste wafer-level-packaging Verfahren angewendet.

Häufig stellt sich hierbei das grundlegende Problem, dass die bei der zur Abdeckung verwendeten Materialien nur schwer zu strukturieren sind, um beispielsweise hindurchführende Kontaktverbindungen für Anschlußkontaktierungen bereitzustellen.

Das Dokument EP 1 503 420 A2 offenbart einen gehäusten Festkörperbildsensor und das Herstellungsverfahren dafür, wobei externe Bondelemente nach Entfernen (mittels z.B. Chemisch-mechanischen Polierens, "CMP") einer Coverglasscheibe freigelegt sind.

Zum Herstellen von Löchern im Gehäusungs- oder Abdeckungsmaterial werden üblicherweise konventionelle Techniken wie z.B. Ultraschallschwingläppen eingesetzt, wobei sich in diesem Fall jedoch nur relativ "große" Löcher von ca. 0,5 mm Durchmesser erzeugen lassen.

Im Dokument WO 99/40624 wurde bereits vorgeschlagen, dass sich mehrere elektrische Kontakte jeweils ein Loch teilen, so dass hierdurch die Anzahl der Löcher reduziert und folglich die Strukturdichte erhöht werden kann. Auch hierbei werden jedoch immer noch sehr kleine, und somit schwer herzustellende Löcher benötigt, wobei zusätzlich die Führung mehrerer Kontaktverbindungen durch ein Loch kompliziert ist.

Die in der Patentanmeldung DE 10147648 A1 beschriebene Erzeugung von "taschenartigen" Strukturen zur Erzeugung von Kavitäten ("Höhlen") und Löchern in einem Glaswafer erfolgt unter Erwärmung einer Glasplatte bis zur deren Verformungstemperatur und deren Formgebung auf einer Negativform mit abschließender Kühlung. Die erzeugten Strukturen im Bereich von 2 - 5 mm führen jedoch noch nicht zu ausreichend kleinen Strukturen. Außerdem ist die Oberflächenqualität der verformten Glasplatte hinsichtlich ihrer optischen Qualität für hochempfindliche optische Bauteile nicht ausreichend.

Daneben sind photostrukturierbare Gläser, wie z.B. "Foturan" verfügbar, mit denen sich über Photolithographie feine Strukturen erzeugen lassen. Nachteilig hierbei ist jedoch, dass diese Gläser einen von Silizium, welches üblicherweise als Trägersubstrat verwendet wird, abweichenden Ausdehnungskoeffizienten besitzen und eine Gehäusung oder Abdeckung mit diesen Gläsern zu Spannungen zwischen Substrat und Gehäuse führt.

Das Dokument "Novel Microstructuring Technology For Glass on Silicon and Glass-Substrates", D. Mund und J. Leib, Electronic Components and Technology, Juni 2004, Bd. 1, Seiten 939-942, offenbart, im Zusammenhang mit Wafer-level-packaging für Bildsensoren, das Aufdampfen von Glasmikrorahmen auf Typischerweise eine ebene Glasscheibe (z.B. aus Borofloat 33).

Nach dem abschließenden Schritt der Gehäusung und/oder der Kontaktfreilegung wird der Wafer in einzelne, zumeist quadratische Chips zerteilt (sogenanntes "Dicing"). Typischerweise wird das Zerteilen mit einer Säge Schnitt für Schnitt mit einem Vorschub von etwa 2 bis 3 mm/min durchgeführt. Daher kann die Dauer des vollständigen Zerteilens eines Wafers in der Größenordnung eines ganzen Tages liegen und verursacht entsprechend hohe Kosten. Die mechanischen Eigenschaften der Passivierungsschichten und Gehäusungen können zudem, je nach Material, insbesondere bei glasartigen Materialien, das Zersägen der Wafer zusätzlich erschweren und verlangsamen.

### Allgemeine Beschreibung der Erfindung:

Die Erfindung hat es sich daher zur Aufgabe gestellt, gehäuste und einfach und flexibel bondbare elektronische, insbesondere opto-elektronische Mikro-Bauelemente und ein vereinfachtes und wirtschaftliches Verfahren zu deren Herstellung zur Verfügung zu stellen.

Die Aufgabe wird durch ein Verfahren gemäß Anspruch 1 und ein elektronisches Bauelement gemäß Anspruch 22 gelöst. Vorteilhafte Weiterbildungen sind Gegenstand der jeweiligen Unteransprüche.

Das erfindungsgemäße Verfahren zur Herstellung von gehäusten elektronischen Bauelementen mit einem integrierten Funktionselement, umfasst die Schritte:
a) Bereitstellen eines Trägersubstrates und eines Coversubstrates,
b) Aufbringen der Funktionselemente auf das Trägersubstrat innerhalb vorgegebener Rasterflächen,
c) Aufbringen von Bondelementen auf das Trägersubstrat innerhalb vorgegebene Rasterbänder, welche zwischen den Rasterflächen verlaufen und Herstellen der Anschlußkontakte zwischen Funktionselementen und Bondelementen,
d) Aufbringen einer Mikrorahmenstruktur aus Glas durch Aufdampfen auf die Unterseite des Coversubstrates und/oder Oberseite des Trägersubstrates, wobei Kavitäten gemäß der Rasterflächen und Kanäle gemäß der Rasterbänder erzeugt werden,
e) Einbringen einer Makrostruktur zumindest auf der Oberseite des Coversubstrates durch Abtragen von Oberflächenbereichen, wobei Gräben gemäß der Rasterbänder des Trägersubstrates erzeugt werden,
f) Zusammenfügen von Träger- und Coversubstrat zu einem Verbundsubstrat, wobei die Funktionselemente gehäust werden und
g) Trennen des Verbundsubstrates entlang einer vorgegebenen Spur innerhalb der Rasterbänder, wobei das Verbundsubstrat in einzelne Bauelemente zerlegt und gleichzeitiges die Bondelemente der vereinzelten Bauelemente freigelegt werden.

Als elektronische Bauelemente werden im Sinne dieser Erfindung Funktionselemente mit elektrischen Anschlüssen definiert. Funktionselemente sind aktive Halbleiterbauelemente und/oder Sensoren und Elemente für die Mikro-Elektromechanik und Mikro-Optoelektronik.

Die Verfahrensschritte bis f) müssen nicht zwangsläufig nacheinander ausgeführt werden, diese können, soweit dies sinnvoll ist, auch parallel oder in anderer Reihenfolge ausgeführt werden. Lediglich Verfahrensschritt g) ist zwangsläufig als letzter Verfahrensschritt auszuführen.

Die Vorgabe der Rasterflächen und -bänder kann durch Markierungen, Masken etc. erfolgen, ist aber auch durch eine entsprechend vorgegebene, beispielsweise steuerbare, Positionierung der Funktionselemente entsprechend einem imaginären Raster auf dem Trägersubstrat möglich.

Das Aufbringen der Bondelemente, die als Kontaktflächen für externe Verbindungen der Bauelemente dienen, und die Herstellung der internen Kontaktierung zwischen Funktionselement und Bondelementen, kann vorzugsweise durch Aufbringen geeigneter leitfähiger Strukturen auf das Trägersubstrat erfolgen. Diese Strukturen können, beispielsweise mit entsprechenden Masken und Beschichtungsverfahren wie Aufdampfen oder Sputtern, in Lift-Off-Technik erzeugt werden. Eine weitere mögliche Kontaktierung ist mittels aufgebrachter Trägerfilme mit vorgefertigten Anordnungen flexibler metallischer Folienleiter (Tape-Automated-Bonding), Flip-Chip-Technik, Beam-Lead-Technik, photolithografische Strukturierungen oder anderen an sich bekannten Verfahren möglich.

Als Trägersubstrate für elektronische Bauelemente werden bevorzugt Halbleiterwafer, insbesondere aus Silizium eingesetzt.

Das Coversubstrat, mit welchem die Kapselung im Waferverbund erfolgen soll, kann eine ebene Halbleiter-, Kunststoff-, Keramik- oder Metallscheibe, vorzugsweise mit einer Dicke von 500 bis 1000 µm, umfassen.

Insbesondere für optische Funktionselemente und/oder für Funktionselemente, für welche eine hermetisch dichte Verkapselung von Bedeutung ist, umfasst das Coversubstrat vorzugsweise eine ebene Glasscheibe mit einer Dicke von 500 bis 1000 µm. Für Coversubstrate eignen sich insbesondere Substrate aus borosilikatischem Glas, z.B. Borofloat 33, wegen seines annähernd gleichen Ausdehnungskoeffizienten zu Silizium.

Die Mikrorahmenstruktur kann sowohl auf das fertige Trägersubstrat, als auch auf das Coversubstrat aufgebracht werden.

Die Mikrorahmenstruktur wird durch Aufdampfen einer Glasschicht, welche vorzugsweise durch eine Maske aufgedampft und strukturiert wird, erzeugt. Zur Strukturierung eignen sich fotolithografische Verfahren, insbesondere die Lift-Off-Technik, welche dem Fachmann grundsätzlich bekannt ist. Als Aufdampfglas wird insbesondere ein borosilikatisches Glas, z.B. das Aufdampfglas 8329 oder G018-189 der Firma SCHOTT Glas verwendet. Ein Vorteil dieses Verfahrens ist das temperaturschonende Aufbringen einer isolierenden Mikrorahmenstruktur aus Glas bei Temperaturen bis 150°C. Entsprechende Verfahren zur Erzeugung einer Mikrostruktur aus Glas sind in der Anmeldungen DE 102 22 609 A1 desselben Anmelders ausgeführt.

Die Mikrorahmenstruktur ist derart ausgebildet, dass beim Zusammenfügen beider Substrate jedes Funktionselement von einem Rahmen umschlossen wird und sich innerhalb der ausgebildeten Kavitäten befindet und die Bondelemente in Bereichen von Kanälen, welche zwischen nebeneinanderliegenden Rahmen ausgebildet werden, angeordnet sind. Die Strukturierung erfolgt gemäß der Anordnung der Funktionselemente und deren Bondelemente, gemäß der Vorgabe der oben beschriebenen Rasterflächen und -bänder.

Zur Erzeugung möglichst kleiner Strukturen auf dem Wafer weisen die Rahmenstege der Mikrorahmenstruktur eine Breite von 1 bis 500 µm, vorzugsweise von 80 bis 100 µm auf. Die Rahmengröße richtet sich nach den Abmessungen der Funktionselemente.

Die Höhe der Rahmenstege der Mikrorahmenstruktur richtet sich hauptsächlich nach den Erfordernissen der integrierten Funktionselemente und weisen vorzugsweise eine Höhe auf, bei der das Coversubstrat die Funktionselemente nicht berührt. Üblicherweise liegen die Größenordnungen für die Steghöhen im Bereich von 1 bis 1000 µm, vorzugsweise von 3 bis 10 µm.

Die Erzeugung der Makrostruktur auf dem Coversubstrat, wobei Gräben gemäß der Rasterbänder des Trägersubstrates erzeugt werden, dient der Reduzierung der Substratdicke auf einer vorgegebenen Spur innerhalb der Rasterbänder, entlang derer das fertige Verbundsubstrat in einzelne Bauelemente zerlegt werden soll. Eine Reduzierung der Glasdicke um 10 bis 80 % in den Sägebereichen ermöglicht später eine erheblich schnellere Chipvereinzelung.

Vorzugsweise werden dazu Gräben, die entsprechend der Kanäle der Mikrostruktur verlaufen, mit einer Breite oder einer mittleren Breite, die maximal der Breite der Kanäle entspricht und vorzugsweise eine Breite von 200 bis 500 µm aufweist, durch Materialabtrag von der Coveroberfläche eingebracht.

Die Gräben der Makrostruktur werden zumindest in die Oberseite des Coversubstrates eingebracht.

Die Erzeugung der Makrostruktur durch Abtragen von Oberflächenbereichen des Coversubstrates erfolgt vorzugsweise mittels Ätzen, Sandstrahlen oder Ultraschallschwingläppen.

Wird die Mikrorahmenstruktur auf die Unterseite des Coversubstrates aufgebracht, erfolgt die Makrostrukturierung auf des Coversubstrates vorzugsweise anschließend.

Zur Kapselung oder Gehäuseausbildung der Funktionselemente im Waferverbund müssen Träger- und Coversubstrat entsprechend justiert zusammengefügt werden. Es bilden sich dabei Kavitäten um die Funktionselemente aus. Die Bondelemente liegen außerhalb diese Kavitäten, d.h. die Rahmenstrukturen werden über die Kontaktierungen (Leiterbahnen) hinweggeführt, um eine elektrische Verbindung des gehäusten Funktionselementes durch die Kapselung hindurch nach außen sicherzustellen.

Wird die Mikrorahmenstruktur auf die Oberseite des Trägersubstrates aufgebracht, werden die Rahmen um die Funktionselemente und über die Kontaktierungen hinweg hermetisch aufgedampft, so dass eine durch den Rahmen hermetisch nach außen führende Kontaktierung sichergestellt ist.

Die Mikrorahmenstruktur der Oberseite des Trägersubstrates und die Unterseite des Coversubstrates werden dann vorzugsweise mittels anodischem Bonding, Fusions Bonding, Sol-Gel-Bonding, Low-Temperature-Bonding, Verlöten oder Verkleben entsprechend justiert zu einem Verbundsubstrat zusammengefügt. Die Ausführung des Coversubstrates aus Glas, d.h. mit einem transparenten Material, erleichtert die Justierung erheblich.

Ist die Mikrorahmenstruktur auf die Unterseite des Coversubstrates aufgebracht, kann der Rahmen nicht direkt mit dem Trägersubstrat gebondet werden, da die Kontaktierungen auf dem Trägersubstrat hermetisch überbrückt werden müssen. Die Verbindung zu einem Verbundsubstrat erfolgt mittels einer Verbindungsschicht, die vorzugsweise auf die Mikrorahmenstruktur aufgetragen wird. In einer bevorzugten Ausführungsform ist die Verbindungsschicht eine Klebeschicht, vorzugsweise aus Epoxydharz mittels derer die beiden Substrate verklebt werden.

Die Vereinzelung der im Waferverbund gehäusten Chips erfolgt vorzugsweise durch Freilegen der Kanäle entlang der Gräben des Coversubstrates, wobei gleichzeitig die Bondelemente freigelegt werden und durch Trennen des Trägersubstrates entlang einer vorgegebenen Spur, die vorzugsweise mittig entlang der Kanäle verläuft.

Die Kanäle können mittels einer Säge, welche vorzugsweise eine relativ große Sägebreite (ca. 100 bis 500 µm) aufweist oder mittels Sandstrahlen oder Ultraschallschwingläppen entlang der Gräben der Makrostruktur des Coversubstrates freigelegt werden. Das Trägersubstrat wird vorzugsweise mittels einer Säge, welche eine relativ geringe Sägebreite (ca. 100 µm) aufweist, getrennt.

Die sehr geringe Materialdicke des Coversubstrates im Bereich der Gräben ermöglicht eine wesentlich kürzere Zeit des sehr kostenintensiven Sägeprozesses.

Mit dem erfindungsgemäßen Verfahren gelingt eine einfache und effektive Herstellung gehäuster Bauelemente. Diese haben außen liegende, gut zugängliche Bondelemente, welche für herkömmliche Technologien und Bondverfahren, beispielsweise Drahtbondverfahren gut geeignet sind.

Die Lösung der Aufgabe gelingt weiterhin mit einem erfindungsgemäßen elektronischen Bauelement, welches herstellbar mit dem vor beschriebenen Verfahren ist und aus einem Verbund aus einem Trägersubstrat und einem Coversubstrat besteht oder ein Verbund aus einem Trägersubstrat und einem Coversubstrat umfasst, wobei auf dem Trägersubstrat zumindest ein Funktionselement und zumindest ein mit dem Funktionselement kontaktiertes Bondelement angeordnet ist, das Coversubstrat ein mikrostrukturiertes Glas ist, welches auf dem Trägersubstrat angeordnet ist und über dem Funktionselement eine Kavität bildet und die Bondelemente sich außerhalb der Kavität auf dem Trägersubstrat befinden.

Das Trägersubstrat umfasst vorzugsweise Silizium. Dadurch weisen das Cover- und Trägersubstrat einen annähernd gleichen Ausdehnungskoeffizienten auf, wodurch es zu keinen Spannungen zwischen den Substraten kommt.

Das Coversubstrat bildet die Gehäusung des Funktionselementes und ist wegen seiner physikalischen Eigenschaften besonders zur Gehäusung von sensorisch aktiven und optisch aktiven Funktionselementen geeignet.

Durch geeignete Verbindungstechnologien, wie beispielsweise im erfindungsgemäßen Verfahren beschrieben, kann außerdem ein dichter Verbund zwischen Träger- und Coversubstrat erreicht werden.

Zur Ausbildung einer Kavität im Coversubstrat, welche das auf dem Trägersubstrat befindliche Funktionselement gehäusen soll, besteht das Coversubstrat vorzugsweise aus einer ebenen Glasscheibe mit einem aufgedampften Mikro-Glasrahmen. Mögliche Verfahren zur Herstellung derartiger Mikrorahmen sind ebenfalls im erfindungsgemäßen Verfahren beschrieben.

Elektronische Bauelemente sollen für viele Anwendungsfälle in kleinen Abmessungen gefertigt werden. In einer vorteilhaften Ausführungsform weist die Glasscheibe eine Dicke von 500 bis 1000 µm, die Rahmenstege der Mikro-Glasrahmen eine Breite von 1 bis 500 µm, vorzugsweise von 80 bis 100 µm und eine Höhe von 1 bis 1000 µm, vorzugsweise von 3 bis 10 µm auf.

Durch das Einbringen der erfindungsgemäßen Makrostruktur in das Coversubstrat und das Vereinzeln des Verbundsubstrats ist das elektronische Bauelement dadurch gekennzeichnet, dass zumindest eine Seitenfläche des Coversubstrats zumindest einen ersten Abschnitt und einen zweiten Abschnitt aufweist, wobei der zumindest erste Abschnitt und der zweite Abschnitt eine unterschiedliche Oberflächenbeschaffenheit aufweisen.

Die unterschiedliche Oberflächenbeschaffenheit ergibt sich durch unterschiedliche Verfahren zum Einbringen der Makrostruktur und zum Zerteilen des Verbundsubstrats in einzelne elektronische Bauelemente. Insbesondere können sich beim Vereinzeln oder Zerteilen des Verbundsubstrats in einzelne elektronische Bauelemente entlang der Sägespur Rillen oder Riefen in den Seitenflächen des Coversubstrates ausbilden. Solche Rillen oder Riefen können jedoch insbesondere nachteilig für gehäuste optisch aktive Funktionselemente sein.

Wie bereits ausgeführt, erfolgt die Erzeugung der Makrostruktur durch Abtragen von Oberflächenbereichen des Coversubstrates und dabei vorzugsweise mittels Ätzen, Sandstrahlen und/oder Ultraschallschwingläppen, wodurch sich zumindest gegenüber dem vorstehenden Sägen eine verbesserte Oberflächengüte in dem Sägebereich der Seitenfläche des Coversubstrates ergeben kann. Zudem kann eine mögliche Rißbildung des Coversubstrates, die sich insbesondere ausgehend von Kanten bilden kann, reduziert werden.

Der zumindest erste Abschnitt und der zweite Abschnitt besitzen eine unterschiedliche Rauheit. Als Ergänzung dazu können der zumindest erste Abschnitt und der zweite Abschnitt eine unterschiedliche Ebenheit und/oder Struktur aufweisen.

Die außerhalb der Gehäusung liegenden und frei zugänglichen Bondelemente umfassen in einer weiteren vorteilhaften Ausgestaltung der Erfindung Draht-bondbare (wire-bonding) oder lötbare Bondpads. Als mögliche Materialien für die Bondpads kommen vorzugsweise Au, Al, TiCu, AlSiCu oder AlSiTi zum Einsatz.

Übliche Bondverfahren sind beispielsweise das wire-bonding mit Thermokompressionsverfahren, Thermokompressionsbonden mit Goldbumps, Ultraschalldrahtbonden, Thermosonicdrahtbonden oder Löten mit Lotbumps. Gerade die Gehäusung aus Glas macht den Einsatz dieser Bondverfahren für empfindliche, insbesondere auch temperaturempfindliche Funktionselemente möglich. Die Kontaktierung und das Zusammenfügen der erfindungsgemäßen Bauelemente zu Baugruppen (Packaging) und Mikro-Systemen wird dadurch mit industriell verbreiteten und modernen Fertigungstechnologien wie beispielsweise das Tape-Automated-Bonding oder Flip-Chip Bonden möglich.

In einer weiteren vorteilhaften Ausführungsform umfasst das elektronisches Bauelement ein auf der Unterseite des Trägersubstrates (1) angeordnetes wärmeableitendes Basissubstrat, vorzugsweise aus Silizium. Trägersubstrat und Basissubstrat sind mittels Kleb- oder Lötverbindung aneinander befestigt. Das wärmeableitende Substrat kann gleichzeitig das Basissubstrat für weitere Bauelemente und/oder Baugruppen bilden.

In einer weiteren vorteilhaften Ausführungsform des elektronisches Bauelementes sind auf den Bondelementen Lotbumps aufgebracht, welche das Trägersubstrat mit Bondelementen der Unterseite eines mit einer Öffnung für das gehäuste Funktionselement versehenen Basissubstrates verbinden. Die Lotbumps sind kleine, elektrisch leitende Materialdepots über die sowohl die elektrische als auch mechanische und/oder thermische Verbindung zwischen Trägerund Basissubstrat hergestellt wird. Werden die Lotbumps zwischen den Bondpads der Substrate aufgeschmolzen, beispielsweise mittels Reflow-Technologie, erfolgt eine sich selbstjustierende, spannungsfreie Verbindung der Substrate. Das Basissubstrat ist beispielsweise Teil einer optischen Baugruppe, innerhalb derer das gehäuste Funktionselement, insbesondere mit einer optischen Funktion, anzuordnen ist.

Erfindungsgemäß umfassen Optische Baugruppe ein Basissubstrat mit einer Öffnung und unterseitigen Bondpads, ein optisches Bauteil, beispielsweise eine Linse, welches oberhalb der Öffnung angeordnet und mit dem Basissubstrat verbunden ist und ein gehäustes elektronischen Bauelement gemäß der vorliegenden Erfindung, welches zumindest ein optisch sensitives Funktionselement umfasst. Das Basissubstrat besitzt definiert angeordnete lötbare Bondpads auf seiner Unterseite, sodass das elektronische Bauelement unterhalb der Öffnung befestigt werden kann. Die Verbindung zwischen Basissubstrat und elektronischen Bauelement ist eine durch aufgeschmolzene Lotbumps, welche sich zwischen den Bondpads des Basissubstrates und den Bondpads des elektronischen Bauelementes befinden, hergestellte, feinzentrierte Verbindung. Dies ermöglicht eine genau zentrierte und äußerst dichte Anordnung des optischen Bauteils, beispielsweise einer Linse zum elektronischen Bauelement.

Derartige optische Baugruppen finden vor allem in digitalen Kameras Verwendung.

Weiterhin liegt im Rahmen der vorliegenden Erfindung ein Verbundsubstrat, welches vorzugsweise mit einem Abschnitt des vorstehend beschriebenen Verfahrens herstellbar oder hergestellt ist, aber noch nicht in einzelne elektronische Bauelemente vereinzelt ist. Die Verwendung eines solchen Verbundsubstrats ist insbesondere dann sinnvoll, wenn die Herstellung des Verbundsubstrates an einem ersten Ort, beispielsweise in einem Reinraum, erfolgt und das Zerteilen an einem anderen Ort, beispielsweise in einem sogenannten Grauraum erfolgt und das Verbundsubstrat erst dorthin transportiert werden muss.

Erfindungsgemäß umfasst das Verbundsubstrat ein Trägersubstrat und ein mit dem Trägersubstrat verbundenes Coversubstrat. Auf dem Trägersubstrat sind innerhalb vorgegebener Rasterflächen Funktionselemente aufgebracht und zudem innerhalb vorgegebener Rasterbänder, welche insbesondere zwischen den Rasterflächen verlaufen, Bondelemente aufgebracht. Die Bondelemente bilden die Anschlusskontakte zu den vorstehend genannten Funktionselementen. Auf der Unterseite des Coversubstrates und/oder auf der Oberseite des Trägersubstrates ist zumindest eine Mikrorahmenstruktur mit aufgedampften Mikrorahmen aus Glas, angeordnet, wobei Kavitäten gemäß der Rasterflächen und Kanäle gemäß der Rasterbänder erzeugt sind und zumindest ein Funktionselement innerhalb einer Kavität angeordnet ist. Zudem ist zumindest eine Makrostruktur auf der Oberseite des Coversubstrates durch Abtragen von Oberflächenbereichen eingebracht, wobei Gräben gemäß der Rasterbänder des Trägersubstrates erzeugt sind.

Die für das erfindungsgemäße Verfahren und das erfindungsgemäße elektronische Bauelement genannten Merkmale sind ebenso für das vorstehend beschriebene Verbundsubstrat anwendbar.

Die Erfindung wird im weiteren an Hand von Ausführungsbeispielen näher erläutert. Es zeigen dazu:

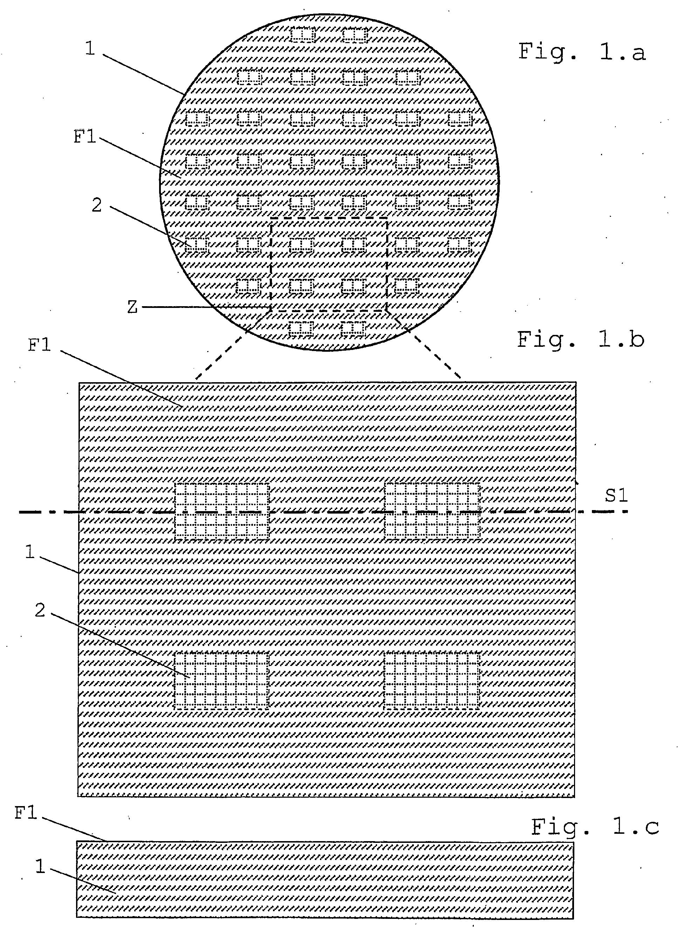

- Fig. 1.a: eine Aufsicht auf ein Trägersubstrat,
- Fig. 1.b: einen vergrößerten Ausschnitt des Trägersubstrates,
- Fig. 1.c: eine Schnittdarstellung des Trägersubstrates aus Fig. 1.b entlang der Schnittlinie S1,
- Fig. 2.a: eine Aufsicht auf ein Trägersubstrat mit Funktionselementen,

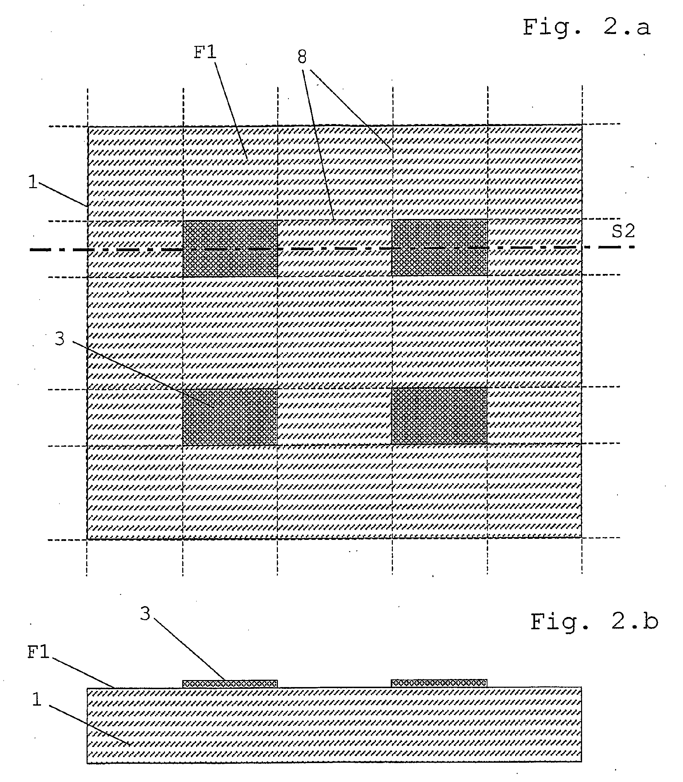

- Fig. 2.b: eine Schnittdarstellung des Trägersubstrates aus Fig. 2.a entlang der Schnittlinie S2,

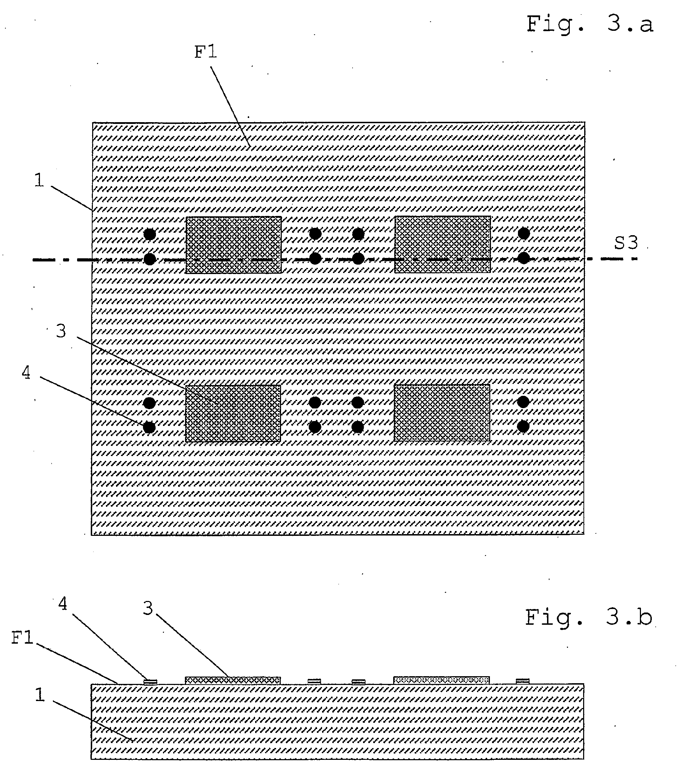

- Fig. 3.a: eine Aufsicht auf ein Trägersubstrat mit Funktionselementen und Bondelementen,
- Fig. 3.b: eine Schnittdarstellung des Trägersubstrates aus Fig. 3.a entlang der Schnittlinie S3,

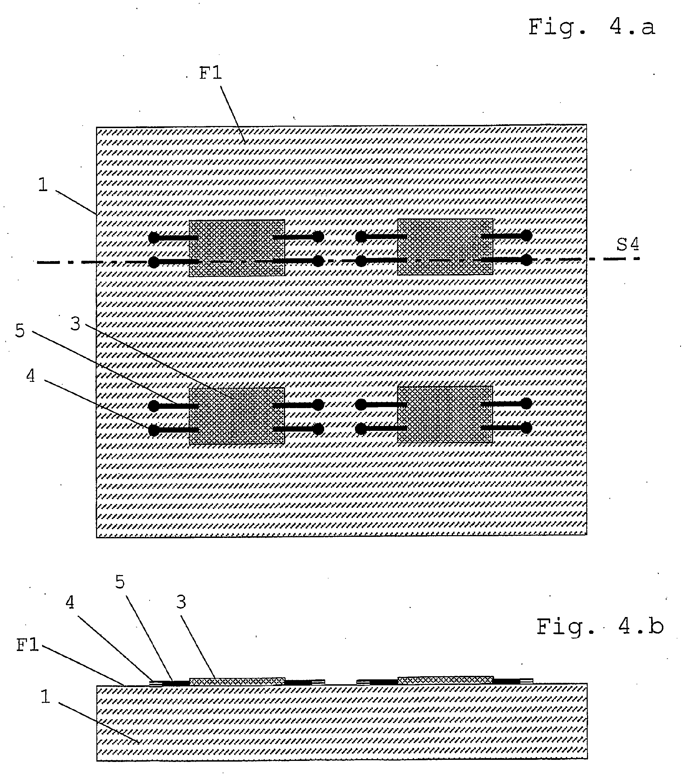

- Fig. 4.a: eine Aufsicht auf ein Trägersubstrat mit Anschlusskontakten zwischen Funktionselementen und Bondpads,
- Fig. 4.b: eine Schnittdarstellung des Trägersubstrates aus Fig. 4.a entlang der Schnittlinie S4,

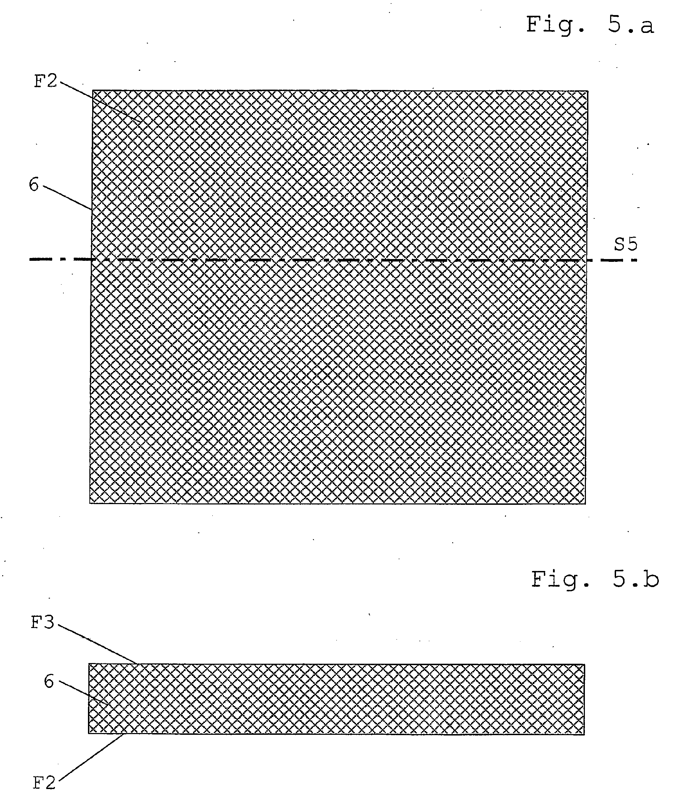

- Fig. 5.a: eine Aufsicht auf die Unterseite eines Coversubstrats,
- Fig. 5.b: eine Schnittdarstellung des Coversubstrates aus Fig. 5.a entlang der Schnittlinie S5,

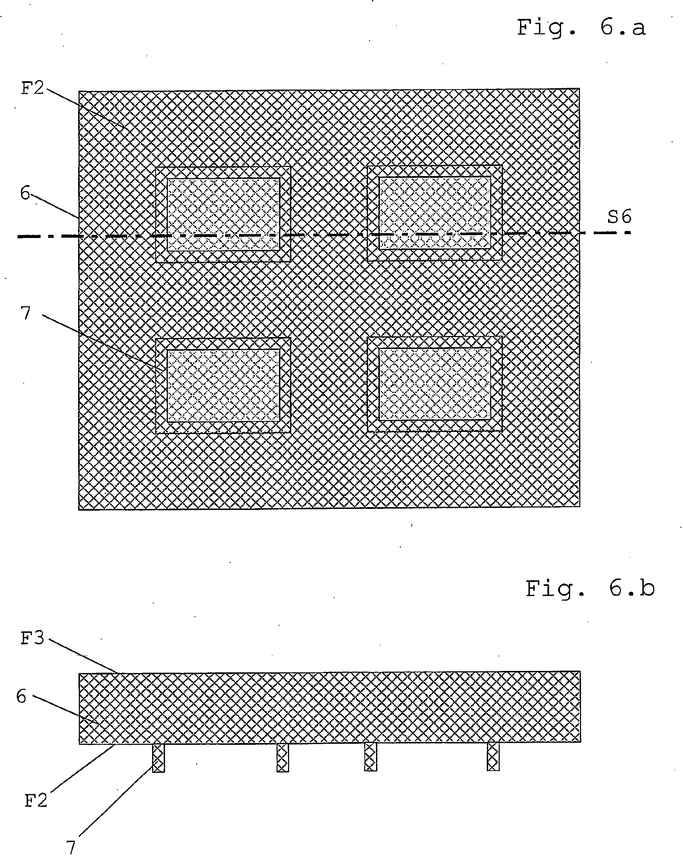

- Fig. 6.a: eine Aufsicht auf die Unterseite eines Coversubstrats mit Mikrorahmenstruktur,
- Fig. 6.b: eine Schnittdarstellung des Coversubstrates aus Fig. 6.a entlang der Schnittlinie S6,

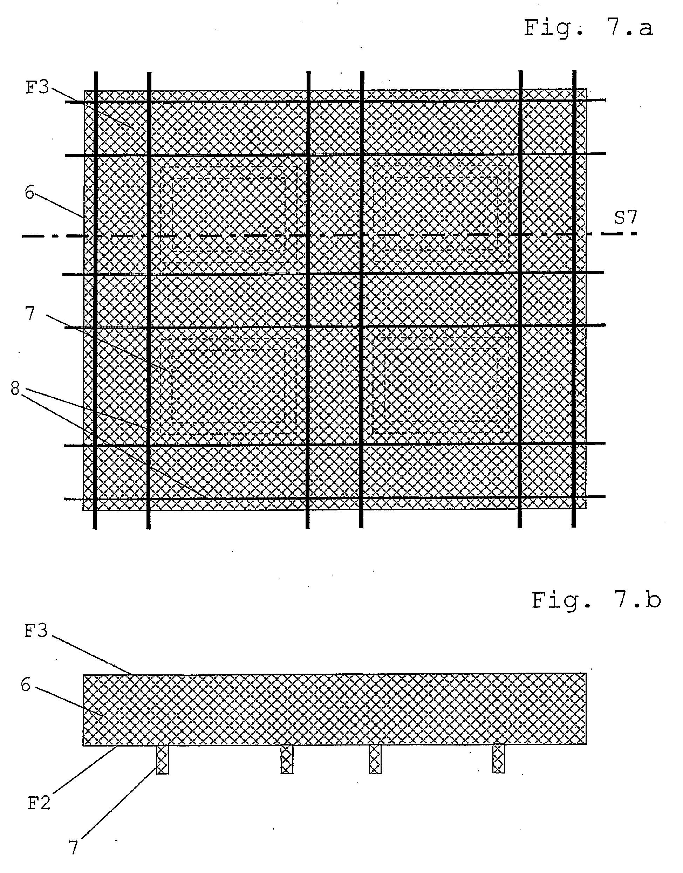

- Fig. 7.a: eine Aufsicht auf die Oberseite des Coversubstrats mit Rasterbändern für die Makrostruktur,
- Fig. 7.b: eine Schnittdarstellung des Coversubstrates aus Fig. 7.a entlang der Schnittlinie S7,

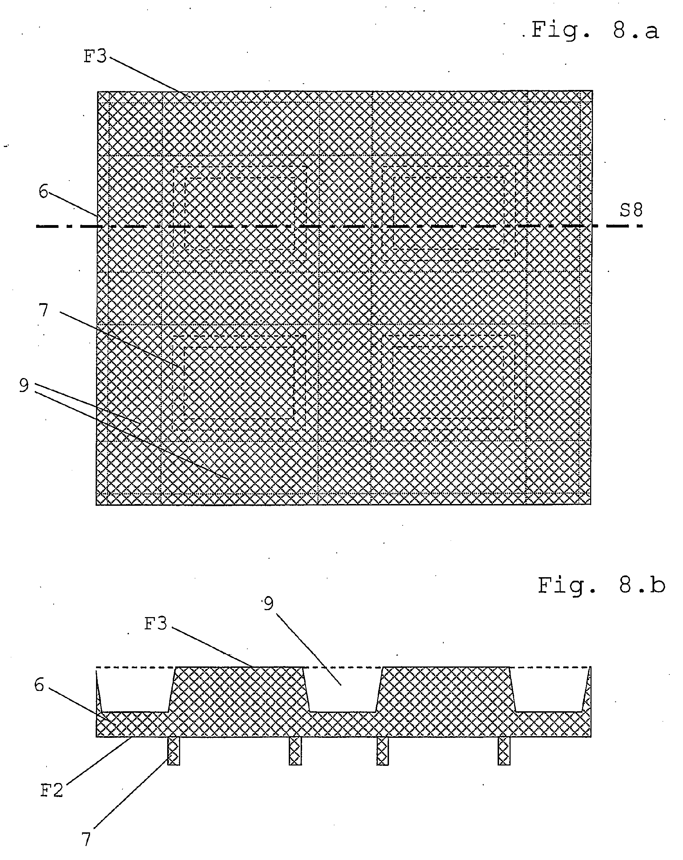

- Fig. 8.a: eine Aufsicht auf die Oberseite des Coversubstrats mit Gräben für die Makrostruktur,
- Fig. 8.b: eine Schnittdarstellung des Coversubstrates aus Fig. 8.a entlang der Schnittlinie S8,

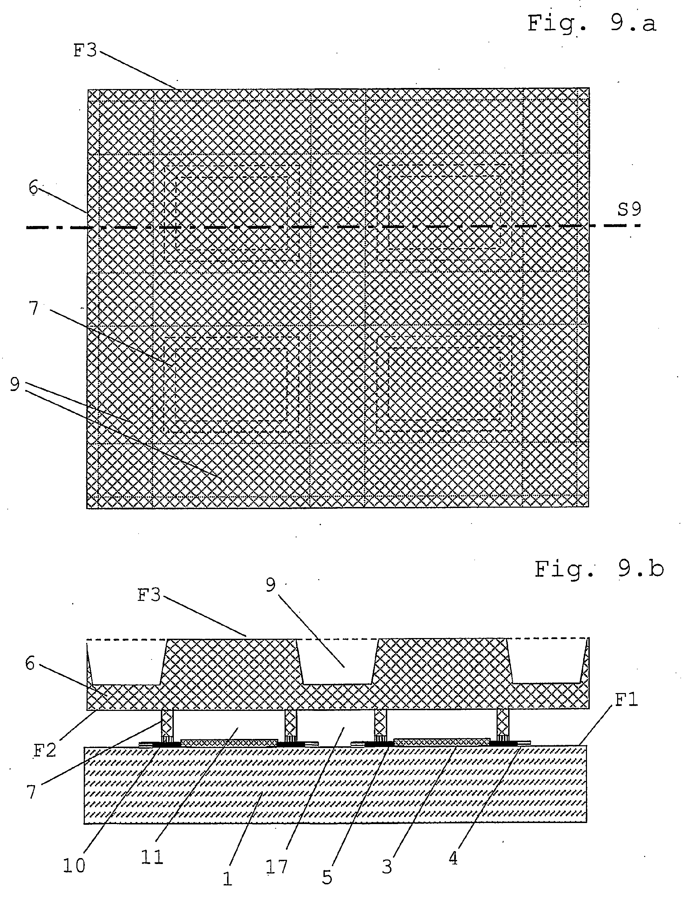

- Fig. 9.a: eine Aufsicht auf die Oberseite des Verbundsubstrats,
- Fig. 9.b: eine Schnittdarstellung des Verbundsubstrats aus Fig. 9.a entlang der Schnittlinie S9,

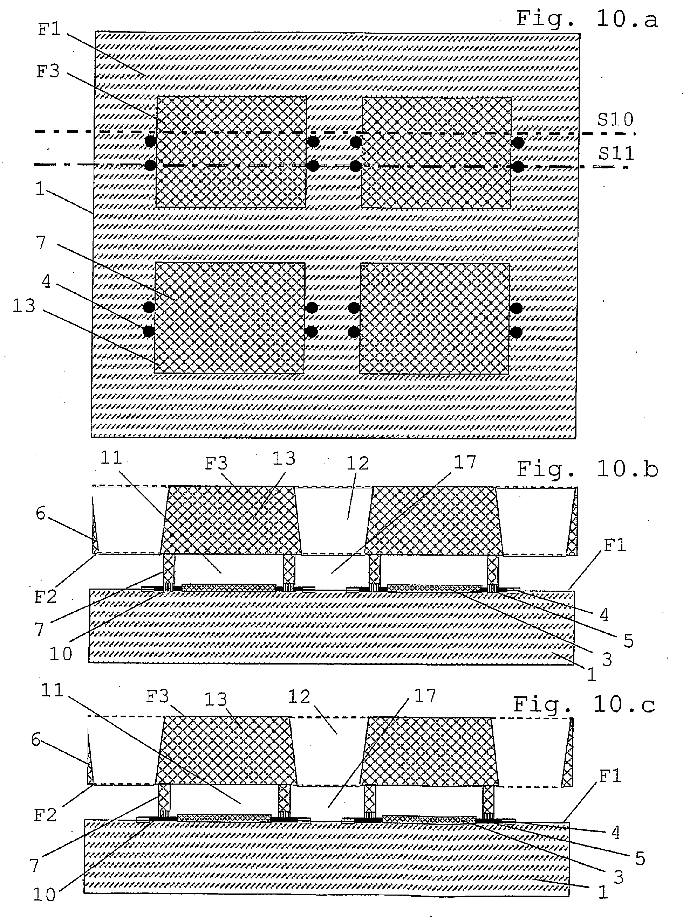

- Fig. 10.a: eine Aufsicht auf die Oberseite des Verbundsubstrats mit freigelegten Bondelementen,
- Fig. 10.b: eine Schnittdarstellung des Verbundsubstrats aus Fig. 10.a entlang der Schnittlinie S10,
- Fig. 10.c: eine Schnittdarstellung des Verbundsubstrats aus Fig. 10.a entlang der Schnittlinie S11,

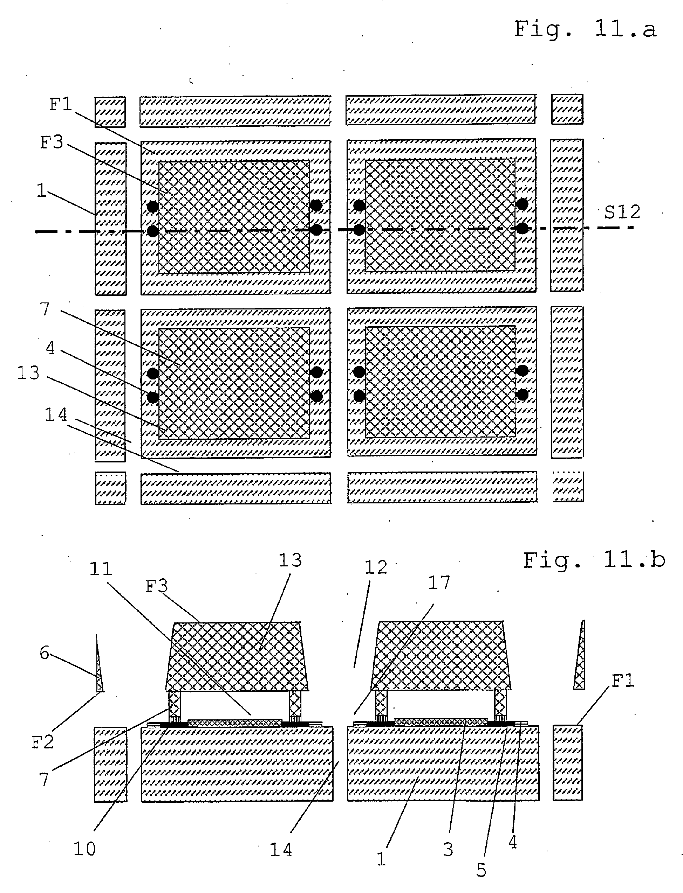

- Fig. 11.a: eine Aufsicht auf das getrennte Verbundsubstrat,
- Fig. 11.b: eine Schnittdarstellung des Verbundsubstrats aus Fig. 11.a entlang der Schnittlinie S12,

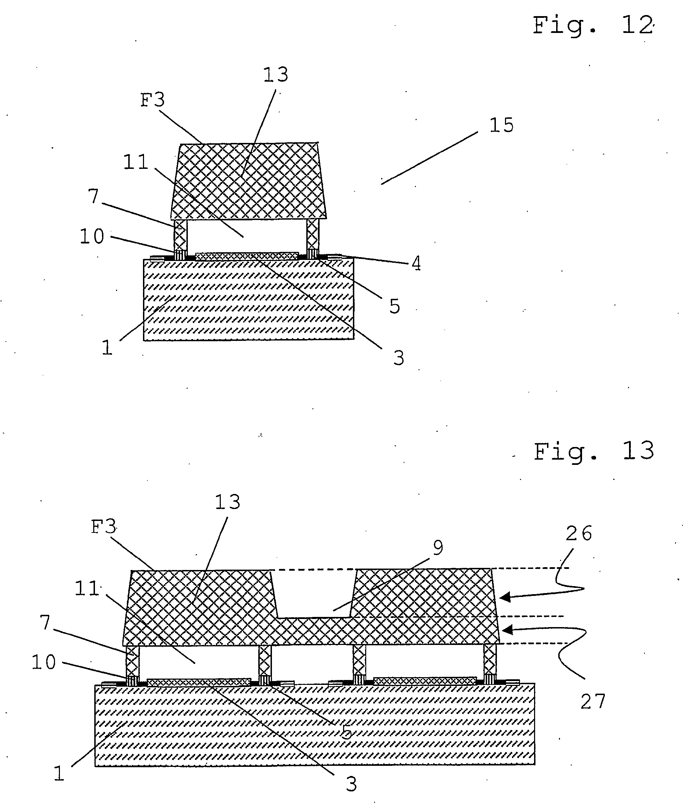

- Fig. 12: ein gehäustes elektronisches Bauelement,
- Fig. 13: ein zum Teil vereinzeltes Verbundsubstrat,

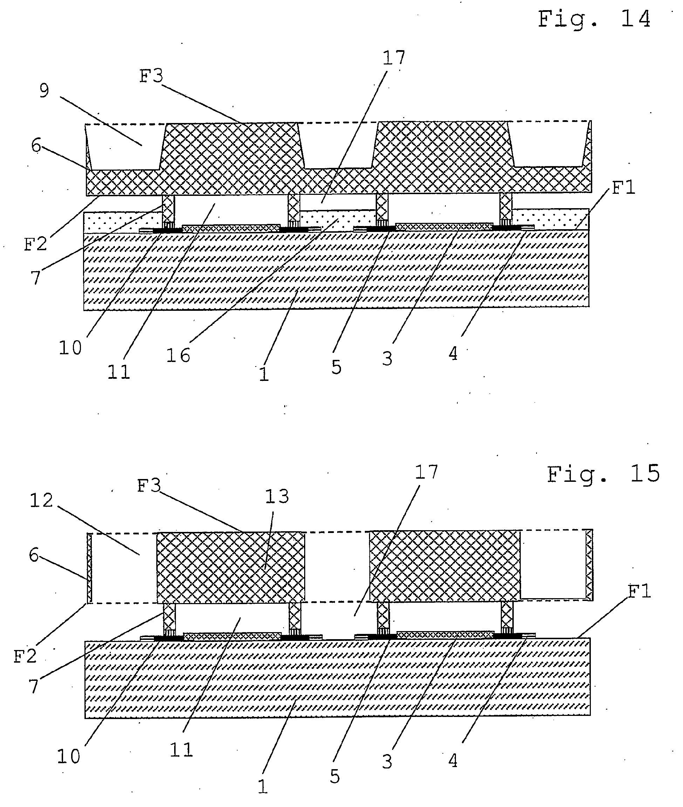

- Fig. 14: eine Schnittdarstellung eines Verbundsubstrates mit geschützten Bondelementen,
- Fig. 15: eine Schnittdarstellung des Verbundsubstrates aus Fig. 14 nach dem Freilegen der Bondelemente,

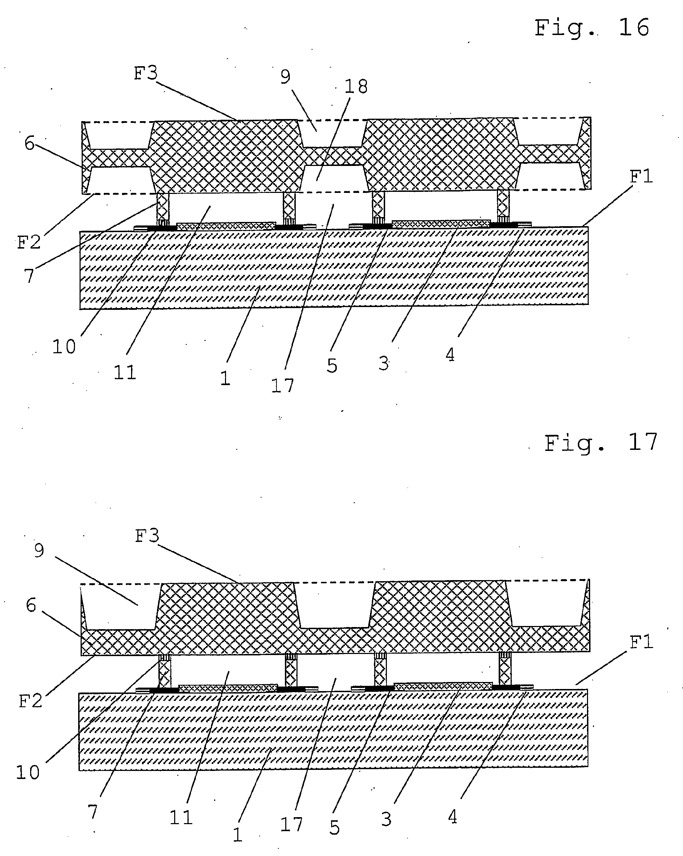

- Fig. 16: eine Schnittdarstellung eines Verbundsubstrates mit beidseitiger Makrostruktur des Coversubstrates,
- Fig. 17: eine Schnittdarstellung eines Verbundsubstrates mit Mikrorahmenstruktur des Trägersubstrates,

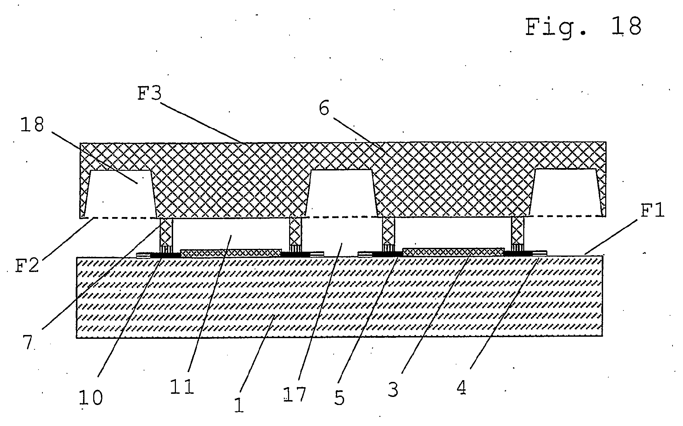

- Fig. 18: eine Schnittdarstellung eines Verbundsubstrates, nicht Teil der vorliegenden Erfindung, mit Makrostruktur in der Unterseite des Coversubstrates,

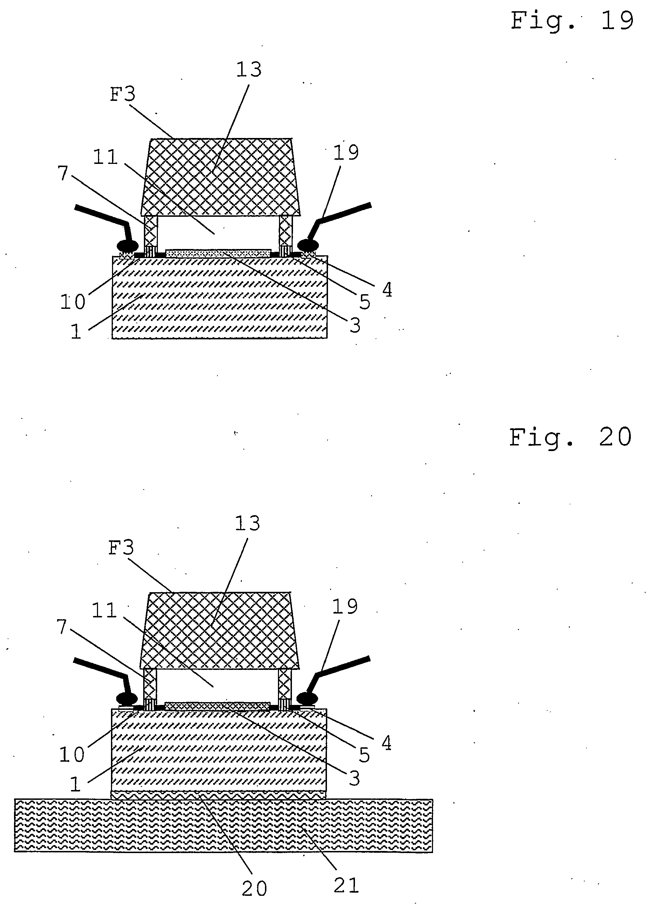

- Fig. 19: eine Schnittdarstellung eines wire-gebondeten elektronischen Bauelementes,
- Fig. 20: eine Schnittdarstellung eines wire-gebondeten elektronischen Bauelementes auf einem Basissubstrat,

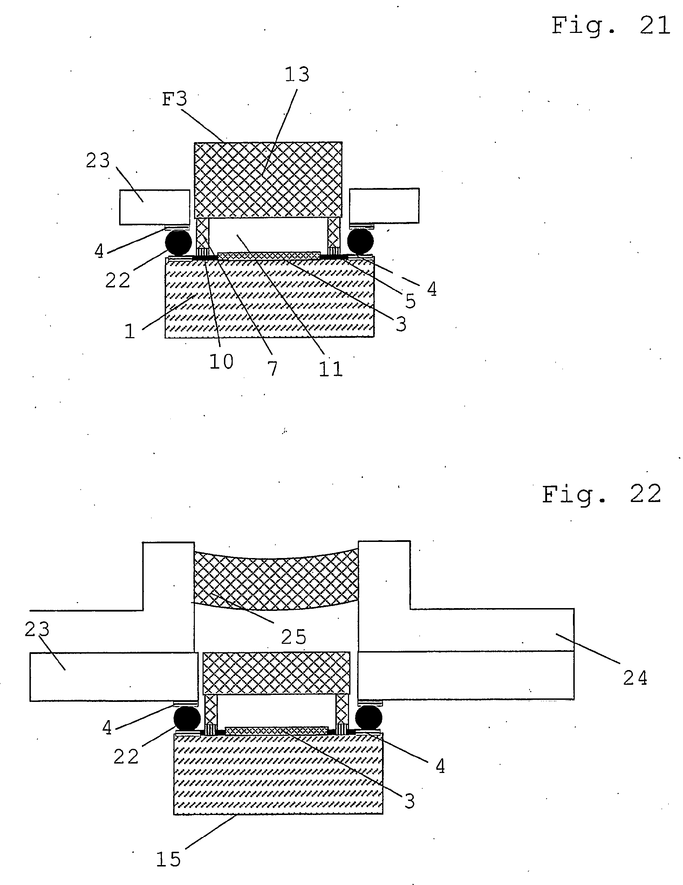

- Fig. 21: eine Schnittdarstellung eines solder-packaging Bauelements und
- Fig. 22: eine Schnittdarstellung einer optischen Baugruppe.

### Herstellen des Trägersubstrates:

Fig. 1.a zeigt einen Wafer in der Ausführung, dass das Trägersubstrat (1) aus Silizium ist. Auf der Oberfläche F1 des Trägersubstrats (1) befindet sich eine Rasterung in Form von Rasterflächen (2).

Die Rasterflächen (2) müssen dabei nicht real auf der Oberfläche F1 vorhanden sein. Sie symbolisieren vielmehr die Anordnung der Funktionselemente (3), die in den weiteren im folgenden beschriebenen Verfahrensschritten auf der Oberfläche F1 des Trägersubstrates (1) aufgebracht werden. Es sei auch darauf hingewiesen, dass die Rasterflächen (2) in anderer Anordnung und Form auf der Oberfläche F1 des Trägersubstrats (1) angeordnet sein können. Jedoch ist in dieser speziellen Ausführungsform die ausgerichtete Anordnung der Bondelemente (4) zwischen den Funktionselementen (3) und das Dicen des Wafers, z.B. mittels Sägen, besonders einfach durchführbar, da das Sägen in geraden Bahnen erfolgen kann.

Fig. 1.b zeigt den in Fig. 1.a markierten Ausschnitt Z in einer vergrößerten Darstellung mit der vorgegebenen Rasterung. Fig. 1.c ist eine schematische Darstellung von Fig. 1.b entlang der Schnittlinie S1.

Bezugnehmend auf Fig. 2.a sind auf der Oberfläche F1 des Trägersubstrats (1) die Funktionselemente (3) mit dem Fachmann an sich bekannten Verfahren, beispielsweise mittels Bond- oder Klebeverbindungen, innerhalb oder auf den vorgegebenen Rasterflächen (2) aufgebracht. Mögliche Ausführungen der Funktionselemente (3) sind beispielsweise mikro-opto-elektronische, mikro-optisch-elektromechanische, elektronische Systeme (MOEMS), z.B. (organische) lichtemittierende und -absorbierende Sensoren ((O)LED). Weitere auch wenn nicht explizit genannte Ausführungen der Funktionselemente (3) sind inbegriffen. Fig. 2.b ist die zu Fig. 2.a gehörige Darstellung entlang der Schnittlinie S2.

Bezugnehmend auf Fig. 3.a sind auf der Oberfläche F1 des Trägersubstrats (1) Bondelemente (4), sogenannte Bondpads, innerhalb der vorgegebenen Rasterbänder (8) aufgebracht. Fig. 3.b ist die zu Fig. 3.a gehörige Darstellung entlang der Schnittlinie S3. Die Lage der Bondelemente (4) ist vorzugsweise so gewählt, dass diese sich in regelmäßiger Anordnung, dicht beabstandet vom Funktionselement (3) befinden und zwischen den Bondelementen (4) verschiedener Funktionselemente (3) eine gerade Spur für die spätere Vereinzelung der Bauelemente verbleibt.

Wie in Fig. 4.a gezeigt, sind die Anschlusskontakte (5) zwischen den Funktionselementen (3) und den Bondelementen (4) auf der Oberfläche F1 des Trägersubstrats (1) aufgedampfte Leiterbahnen aus Aluminium. Alternativ können die Anschlusskontakte (5) auch Gold, Wolfram oder Titan-Wolfram umfassen. Fig. 4.b ist die zu Fig. 4.a gehörige Darstellung entlang der Schnittlinie S4.

Die getrennt beschriebenen Verfahrensschritte, Aufbringen der Bondelemente (4) und Aufbringen der Anschlusskontakte (5), können auch in einem Verfahrensschritt ablaufen. D.h. in einer weiteren hier nicht im Detail dargestellten Ausführung kann der Anschlusskontakt (5) somit auch direkt das Bondelement (4) umfassen.

Dem Fachmann ist es naheliegend, dass die in den Figuren 2, 3 und 4 beschriebenen Verfahrensschritte auch in veränderter Reihenfolge stattfinden können.

### Herstellung des Coversubstrats:

Fig. 5a zeigt einen Ausschnitt (analog dem Ausschnitt Z des Trägersubstrats (1) in den Figuren 1-4) des Coversubstrats (6) mit seiner Unterseite F2. Das Coversubstrat (6) ist aus Glas und dabei in seinen thermo-mechanischen Eigenschaften an das Trägersubstrat (2) angepasst. Fig. 5.b ist die zu Fig. 5.a gehörige Darstellung entlang der Schnittlinie S5 und zeigt neben der Unterseite F2 des Coversubstrats noch zusätzlich dessen Oberseite F3.

Fig. 6a zeigt den selben Ausschnitt des Coversubstrats (6) wie in Fig. 5 nach dem Aufbringen der Mikrorahmenstruktur (7) aus Glas durch Aufdampfen auf der Unterseite F2 des Coversubstrats (6). Fig. 6.b ist die zu Fig. 6.a gehörige Darstellung entlang der Schnittlinie S6.

Die Herstellung der Mikrorahmenstruktur (7) ist in den Figuren nicht explizit dargestellt, wird aber im folgenden skizziert.

Auf die zu strukturierende Unterseite F2 wird ein Fotolack mit einem dem Fachmann bekannten Verfahren aufgebracht und fotolithografisch strukturiert. Zur Erzeugung der mikrorahmenstrukturen (7), kann eine Schattenmaske, eine haftende oder eine nicht haftende Abdeckmaske verwendet werden. Die Unterseite F2 weist dann analog zur Rasterung, um jede Rasterfläche (2) eine rechteckige Aussparung für den auszubildenden Rahmen auf. Die spätere Gehäuseoberfläche wird durch die Maske abgedeckt. Innerhalb der Aussparungen der Maske wird das Glas unmittelbar auf dem Coversubstrat (6) abgeschieden. Die Glasschicht wird zum Beispiel mittels Plasma-Ionenestrahl-unterstütztem Elektronenstrahlverdampfung aufgebracht. Nachfolgend werden die auf der Lackmaske befindlichen Bereiche der aufgedampften Glasschicht mittels Lift-Off entfernt. Hierzu wird der Fotolack in Aceton abgelöst. Das abgeschiedene Glas in den Bereichen der Aussparungen der Photomaske bildet die gewünschte Mikrorahmenstruktur (7).

Fig. 6.a und Fig. 6.b zeigen einen Ausschnitt des Coversubstrates (6) nach dem Aufbringen der Mikrorahmenstruktur (7).

Bezugnehmend auf Fig. 7 sind auf der Oberseite F3 des Coversubstrats (6) die senkrechten und waagrechten Rasterbänder (8), welche sich zwischen den Rasterflächen (2) des Trägersubstrats (1) ausbilden, markiert. Innerhalb dieser Rasterbänder (8) erfolgt der Abtrag von Oberflächenbereichen zur Erzeugung der Makrostruktur des Coversubstrats (6). Fig. 7.b ist die zu Fig. 7.a gehörige Darstellung entlang der Schnittlinie S7.

Auf der Oberseite F3 des Coversubstrats (6) werden mit einem subtraktiven Verfahren, beispielsweise mit einem Ultraschallschwingläppverfahren, im Bereich der Rasterbänder (8) Vertiefungen bzw. Gräben (9) erzeugt. Da das subtraktive Verfahren nur im dem Bereich der Rasterbänder (8), d.h. außerhalb des "Sichtbereichs" der Funktionselemente (3), angewendet wird, bleibt die optische Funktion/Güte des Coversubstrats (6) erhalten. Fig. 8.a zeigt dazu das mit den Gräben (9) versehene Coversubstrat und Fig. 8.b eine entsprechende Schnittdarstellung des mikro- und makrostrukturierten Coversubstrats (6) entlang der Schnittlinie S8.

Selbstverständlich kann die Reihenfolge der einzelnen Verfahrensschritte verändert werden. So können zum Beispiel die Gräben (9) der Makrostruktur auf die Oberseite F3 des Coversubstrats (6) auch vor Aufdampfen der Mikrorahmenstruktur (7) auf der Unterseite F2 des Coversubstrats (6) erzeugt werden.

### Herstellen des Verbundsubstrats:

Die mikrostrukturierte Unterseite F2 des Coversubstrats (6) wird gegenüber der Oberseite F1 des Trägersubstrats (1) positioniert und gemäß der Rasterung zueinander ausgerichtet. Bezug nehmend auf Fig. 9 werden das mikround makrostrukturierte Coversubstrat (6) und das Trägersubstrat (1) mit dem Funktionselement (3) und kontaktierten Bondelementen (4) zu einem Verbundsubstrat zusammengefügt und an der Unterseite der Mikrorahmenstruktur (7) über eine Bondfläche (10) miteinander verbunden. Zum Bonden wird beispielsweise ein Epoxid-Klebstoff im auf die Bondfläche (10) aufgetragen. Aufgrund der Höhe der Rahmen der Mikrorahmenstruktur (7) entstehen Kavitäten (11) und Kanäle (17) zwischen Trägersubstrat (1) und Coversubstrat (6). Innerhalb der Kavitäten (11) befinden sich die Funktionselemente (3), innerhalb der Kanäle (17) befinden sich die Bondelemente (4). Das Ergebnis ist eine Vielzahl von Funktionselementen (3), welche auf Waferebene gehäust sind. Fig. 9.b ist die zu Fig. 9.a gehörige Darstellung entlang der Schnittlinie S9.

### Vereinzeln der Bauelemente:

Im abschließenden Verfahrensschritt erfolgt das Sägen des Verbundsubstrats. Das Sägen des Verbundsubstrates erfolgt durch Dicen des Coversubstrats (6) und Dicen des Trägersubstrats (1) und kann dabei in einem einzigen Schritt oder in nacheinander folgenden Schritten erfolgen.

Bezugnehmend auf Fig. 10.a wird das Coversubstrat (6) entlang der in Fig. 9.a gezeigten Gräben (9) der Makrostrukturen in senkrechten und waagrechten Bahnen mittels Sägen mit einer Sägebreite, die der breite der Gräben (9) entspricht, geöffnet. Durch das Öffnen der Makrostruktur werden in einem Verfahrensschritt durch den geöffneten Bereich (14) im Coversubstrat (6) die Bondelemente (4) freigelegt und im nicht geöffneten Bereich jedes Funktionselement (3) mit einem Gehäuse (13) umgeben. Fig. 10.b ist die zu Fig. 10.a gehörige Darstellung entlang der Schnittlinie S10. Fig. 10.c ist die zu Fig. 10.a gehörige Darstellung entlang der Schnittlinie S11. Bezugnehmend auf Fig. 11.b erfolgt das Dicen des Trägersubstrats (1) mit einer wesentlich geringeren Sägebreite im Öffnungsbereich (14) des Trägersubstrats (1). Die Sägespur ist dabei durch die Aufteilung der Funktionselemente (3) und Bondelemente (4) auf dem Trägersubstrat vorgegeben und verläuft vorzugsweise auf geraden Linien, mittig innerhalb der Rasterbänder (8). Fig. 11.b ist die zu Fig. 11.a gehörige Darstellung entlang der Schnittlinie S12.

Fig. 12 zeigt ein gehäustes elektronisches Bauelement (15) mit integriertem Funktionselement (3) nach dem Vereinzeln.

Zur Veranschaulichung der unterschiedlichen Oberflächenbeschaffenheit der Seitenflächen (26, 27) des Coversubstrates (6) oder des Gehäuses (13) zeigt Fig. 13. ein nur zum Teil vereinzeltes Verbundsubstrat. Die Seitenfläche (26, 27) oder die Seite des Coversubstrates (6) weist in der vorliegenden Darstellung einen ersten seitlichen Abschnitt (26) und einen zweiten seitlichen Abschnitt (27) auf.

Die Höhe des ersten Abschnitts (26) entspricht im wesentlichen der Tiefe der Makrostruktur oder der Gräben (9), wobei der erste Abschnitt (26) nach oben hin in die Oberseite (F3) des Coversubstrates (6) und nach unten hin in den zweiten Abschnitt (27) übergeht oder mündet. Der zweite Abschnitt (27) selbst mündet an seiner unteren Seite in die Unterseite (F2) des Coversubstrates (6), wobei seine Höhe im wesentlichen der um die Tiefe der Makrostruktur reduzierten Höhe des Coversubstrates (6) im Bereich der Makrostruktur entspricht.

Im zweiten Abschnitt (27) können sich in der seitlichen Oberfläche des Coversubstrates (6) oder des Gehäuses (13) während des Vereinzelns mittels Sägen Rillen, tiefe Rillen oder sogar Riefen ausbilden, welche insbesondere für optische Anwendungen nachteilig sein können. Die Oberflächenbeschaffenheit des ersten seitlichen Abschnitts (26) resultiert dagegen aus dem Verfahren, welches zum Einbringen der Makrostruktur oder Gräben (9), wie beispielsweise Läppen, verwendet wird. Entsprechend weisen der erste Abschnitt (26) und der zweite Abschnitt (27) eine unterschiedliche Oberflächenbeschaffenheit auf. Insbesondere weist der erste Abschnitt (26) zumindest gegenüber dem zweiten Abschnitt (27) eine verbesserte Oberflächenbeschaffenheit auf. In der vorliegenden Erfindung ist die Oberfläche des ersten Abschnitts (26) glatter als die des zweiten Abschnitts (27). Der erste Abschnitt (26) weist eine geringere Rauheit, beispielsweise bestimmt nach DIN 4768-1, als der zweite Abschnitt (27) auf. Eine glatte Oberfläche des ersten Abschnitts (26) ist insbesondere dann vorteilhaft, wenn der erste Abschnitt (26) in die Oberseite (F3) des Coversubstrates (6) mündet und das Funktionselement (3) ein optisch wirksames Funktionselement ist. Der erste Abschnitt (26) zeichnet sich zumindest gegenüber dem zweiten Abschnitt (27) durch verbesserte Abbildungseigenschaften auf, wodurch sogar seitlich versetzt positionierte Objekte erfasst werden können.

### Varianten:

Neben dem beschriebenen Ausführungsbeispiel sind eine Vielzahl weiterer Varianten möglich, wovon einige beispielhaft im weiteren aufgeführt werden.

Gemäß Fig. 14 können vor dem Zusammenfügen von Träger- und Coversubstrat (1,6) die Bondelemente (4) mit einer temporären Schutzschicht (16) überzogen werden. Die Schutzschicht (16) verhindert, dass die beim Sägen entstehenden Staub- und Schmutzpartikel die Bondelemente (4) verunreinigen und somit deren Funktionsfähigkeit beeinträchtigen können. Zum Freilegen der Bondelemente (4) wird die Schutzschicht (16) nach dem Dicen des Wafers, z.B. mittels Ätzen, wieder entfernt.

Eine weitere Ausführungsform des erfinderischen Verfahrens gemäß der Fig. 15 kann auch darin bestehen, dass ein anderes "Sägeverfahren" verwendet wird, welches zu einer anderen, hier z.B. rechteckigen Randform des Gehäuses (13) führen kann.

Aus Fig. 16 ist noch ein weiteres Ausführungsbeispiel zu entnehmen, bei welchem sowohl auf der Oberseite F3 Gräben (9) als auch der Unterseite F2 der Coversubstrats (6) Gräben (18) für eine Makrostrukturierung erzeugt werden.

Eine weitere Ausführungsform im Sinne von Fig. 17 könnte auch darin bestehen, dass das die Oberseite F1 des Trägersubstrats (1) mit der Mikrorahmenstruktur (7), die Unterseite F2 des Coversubstrats (6) unbehandelt und nur die Oberseite F3 des Coversubstrats (6) eine Makrostruktur aufweist.

Ein Beispiel, nicht Teil der vorliegenden Erfindung, zeigt Fig. 18, wobei die Makrostruktur im vorliegenden Fall nur in der Unterseite des Coversubstrates (6) eingebracht ist.

Fig. 19 zeigt ein gehäustes elektronisches Bauelement (15) mit über die Anschlüsse (5) kontaktierten, außerhalb der Kavität (11) liegenden, Bondelementen (4). Die Bondelemente sind als lötbare Bondelemente (4) ausgebildet über die mittels Löten ein Draht (19) zur Kontaktierung weiterer nicht in der Zeichnung dargestellter Bauteile angebracht werden kann.

Fig. 20 zeigt ein gehäustes elektronisches Bauelement (15), welches auf der Unterseite des Trägersubstrates (1) mittels einer Kleb- oder Lötverbindung (20) auf einem wärmeableitenden Basissubstrat (21) angeordnet ist.

In einer weiteren Ausführungsform zeigt Fig. 21 ein gehäustes elektronisches Bauelement (15) mit über die Anschlüsse (5) kontaktierten, außerhalb der Kavität (11) liegenden, Bondelementen (4). Auf den Bondelementen (4) sind Lotbumps (22) aufgebracht. Diese sind vorteilhaft aus Zinn ausgebildet. Bei einer Verbindung mit einem Basissubstrat (23), auf welchem ebenfalls Bondpads (4) aufgebracht sind, welche sich in entsprechender, hochgenau positionierter Anordnung zu den Bondpads (4) des Trägersubstrates (1) befinden, mittels Reflow-Technik, bei welcher die Lotbumps erwärmt und aufgeschmolzen werden, entsteht eine selbstjustierende, feinzentrierte Anordnung der Substrate (1, 23) zueinander.

Fig. 22 zeigt den Ausschnitt einer optischen Baugruppe mit einem gehäusten elektronischen Bauelement (15). Dieses ist gegenüber von einem optischen Bauteil (25), beispielsweise einer Linse, angeordnet. Das optische Bauteil (25) ist mittels einer geeigneten Halterung (24) an dem Basissubstrat (23) befestigt.
Das elektronische Bauelement (15) ist ebenfalls am Basissubstrat (23) befestigt. Die Verbindung ist wie vor beschrieben, mittels Reflow-Technik hergestellt worden. Damit sind das optische Bauteil (25) und der optische Sensor (3) extrem genau zueinander justiert und zentriert angeordnet. Die sehr dichte Anordnung der Linse zum optischen Sensor (3) ermöglicht außerdem eine verbesserte Auflösung eines optischen Signals.

### Bezugszeichenliste:

- 1: Trägersubstrat
- 2: Rasterfläche
- 3: Funktionselement
- 4: Bondelement
- 5: Anschlusskontakt (zwischen Funktionselement und Bondelement)
- 6: Coversubstrat
- 7: Mikrorahmenstruktur
- 8: Rasterband
- 9: Graben (auf der Oberseite F3 des Coversubstrats)
- 10: Bondfläche, Bondpad
- 11: Kavität
- 12: Öffnungsbereich des Coversubstrats
- 13: Gehäuse
- 14: Öffnungsbereich des Trägersubstrats
- 15: Einzelnes Bauelement
- 16: Schutzschicht der Bondelemente
- 17: Kanal
- 18: Graben (auf der Unterseite F2 des Coversubstrats)
- 19: Draht
- 20: Kleb-Löt-Verbindung
- 21: wärmeableitendes Basissubstrat
- 22: Lötbumps
- 23: Basissubstrat
- 24: Halterung
- 25: Optisches Bauteil, Linse
- 26: Erster seitlicher Abschnitt des Coversubstrats
- 27: Zweiter seitlicher Abschnitt des Coversubstrats

- Z: Vergrößerter Ausschnittsbereich des Trägersubstrats

- F1: Oberseite des Trägersubstrats
- F2: Unterseite des Coversubstrats
- F3: Oberseite des Coversubstrats

- S1: Schnittlinie Trägersubstrat
- S2: Schnittlinie Trägersubstrat
- S3: Schnittlinie Trägersubstrat
- S4: Schnittlinie Trägersubstrat

- S5: Schnittlinie Coversubstrat
- S6: Schnittlinie Coversubstrat
- S7: Schnittlinie Coversubstrat
- S8: Schnittlinie Coversubstrat

- S9: Schnittlinie Verbundsubstrat
- S10: Schnittlinie Verbundsubstrat
- S11: Schnittlinie Verbundsubstrat
- S12: Schnittlinie getrenntes Verbundsubstrat

## Patentansprüche

1. Verfahren zur Herstellung von gehäusten elektronischen Bauelementen (15) mit einem integrierten Funktionselement (3), umfassend die Schritte:
a) Bereitstellen eines Trägersubstrates (1) und Coversubstrates (6),
b) Aufbringen der Funktionselemente (3) auf das Trägersubstrat (1) innerhalb vorgegebener Rasterflächen (2),
c) Aufbringen von Bondelementen (4) auf das Trägersubstrat(1) innerhalb vorgegebener Rasterbänder (8), welche zwischen den Rasterflächen (2) verlaufen und Herstellen der Anschlusskontakte (5) zwischen Funktionselementen (3) und Bondelementen (4),
d) Aufbringen einer Mikrorahmenstruktur (7) aus Glas durch Aufdampfen auf die Unterseite des Coversubstrates (6) und/oder Oberseite des Trägersubstrates (1), wobei Kavitäten (11) gemäß der Rasterflächen (2) und Kanäle (17) gemäß der Rasterbänder (8) erzeugt werden,
e) Einbringen einer Makrostruktur zumindest auf der Oberseite des Coversubstrates (6) durch Abtragen von Oberflächenbereichen, wobei Gräben (9) gemäß der Rasterbänder (8) des Trägersubstrates (1) erzeugt werden,
f) Zusammenfügen von Träger- und Coversubstrat (1,6) zu einem Verbundsubstrat, wobei die Funktionselemente (3) gehäust werden und
g) Trennen des Verbundsubstrates entlang einer vorgegebenen Spur innerhalb der Rasterbänder (8), wobei das Verbundsubstrat in einzelne Bauelemente (15) zerlegt und gleichzeitig die Bondelemente(4) der vereinzelten Bauelemente (15) freigelegt werden.

2. Verfahren nach Anspruch 1, **dadurch gekennzeichnet, dass** als Trägersubstrat (1) ein Halbleiterwafer bereitgestellt wird.

3. Verfahren nach Anspruch 2, **dadurch gekennzeichnet, dass** als Trägersubstrat (1) ein Halbleiterwafer aus Silizium bereitgestellt wird.

4. Verfahren nach einem der vorhergehenden Ansprüche, **dadurch gekennzeichnet, dass** das Aufbringen der Funktionselemente (3) das Aufbringen von aktiven Halbleiter-Funktionselementen (3) umfasst.

5. Verfahren nach einem der vorhergehenden Ansprüche, **dadurch gekennzeichnet, dass** das Aufbringen der Funktionselemente (3) das Aufbringen von sensorisch aktiven Funktionselementen (3) umfasst.

6. Verfahren nach einem der vorhergehenden Ansprüche, **dadurch gekennzeichnet, dass** das Aufbringen der Funktionselemente (3) das Aufbringen von optisch aktiven Funktionselementen (3) umfasst.

7. Verfahren nach einem der vorhergehenden Ansprüche, **dadurch gekennzeichnet, dass** als Coversubstrat (6) eine ebene Halbleiter-, Kunststoff-, Keramik- oder Metallscheibe mit einer Dicke von 500 bis 1000 µm bereitgestellt wird.

8. Verfahren nach einem der vorhergehenden Ansprüche, insbesondere nach Anspruch 6, **dadurch gekennzeichnet, dass** als Coversubstrat (6) eine ebene Glasscheibe mit einer Dicke von 500 bis 1000 µm bereitgestellt wird.

9. Verfahren nach einem der vorhergehenden Ansprüche, **dadurch gekennzeichnet, dass** die Rahmenstege der Mikrorahmenstruktur (7) mit einer Breite von 1 bis 500 µm, vorzugsweise von 80 bis 100 µm, und/oder mit einer Höhe von 1 bis 1000 µm, vorzugsweise von 3 bis 10 µm, aufgebracht werden.

10. Verfahren nach einem der vorhergehenden Ansprüche, **dadurch gekennzeichnet, dass** das Aufbringen der Mikrorahmenstruktur (7) die Schritte:
- Aufbringen einer Maske, welche die Mikrorahmenstruktur (7) negativ abbildet,
- Aufdampfen einer Glasschicht und
- Entfernen der Maske mittels Lift-Off-Technik umfasst.

11. Verfahren nach einem der vorhergehenden Ansprüche, **dadurch gekennzeichnet, dass** die Gräben (9) der Makrostruktur mit einer Breite von 5 bis 1000 µm, vorzugsweise von 200 bis 500 µm eingebracht werden.

12. Verfahren nach einem der vorhergehenden Ansprüche, **dadurch gekennzeichnet, dass** im Bereich der Gräben (9) der Makrostruktur die Dicke des Coversubstrats (6) um 10 bis 80 % reduziert wird.

13. Verfahren nach einem der vorhergehenden Ansprüche, **dadurch gekennzeichnet, dass** die Gräben (9) der Makrostruktur auf die Ober- und Unterseite des Coversubstrates (6) eingebracht werden.

14. Verfahren nach einem der Ansprüche 11 bis 12, **dadurch gekennzeichnet, dass** das Einbringen einer Makrostruktur durch Abtragen von Oberflächenbereichen des Coversubstrates (6) mittels Ätzen, Sandstrahlen oder Ultraschallschwingläppen erfolgt.

15. Verfahren nach einem der vorhergehenden Ansprüche, **dadurch gekennzeichnet, dass** die Mikrorahmenstruktur (7) auf die Unterseite des Coversubstrates (6) aufgebracht wird.

16. Verfahren nach Anspruch 15, **dadurch gekennzeichnet, dass** auf die Mikrorahmenstruktur (7) eine Klebschicht aufgetragen wird, vorzugsweise aus Epoxydharz, und die Oberseite des Trägersubstrates (1) mit der Mikrorahmenstruktur (7) der Unterseite des Coversubstrates (6) zu einem Verbundsubstrat verklebt wird.

17. Verfahren nach einem der vorhergehenden Ansprüche, **dadurch gekennzeichnet, dass** die Mikrorahmenstruktur (7) auf die Oberseite des Trägersubstrates (1) aufgebracht wird.

18. Verfahren nach Anspruch 17, **dadurch gekennzeichnet, dass** die Mikrorahmenstruktur (7) der Oberseite des Trägersubstrates (1) und die Unterseite des Coversubstrates (6) mittels anodischem Bonding, Fusion Bonding, Sol-Gel-Bonding, Low-Temperature-Bonding, Verlöten oder Verkleben zu einem Verbundsubstrat zusammengefügt werden.

19. Verfahren nach einem der vorhergehenden Ansprüche, **dadurch gekennzeichnet, dass** das Verbundsubstrat durch Freilegen der Kanäle (17) entlang der Gräben (9) des Coversubstrates (6) und durch Trennen des Trägersubstrates (1) entlang der vorgegebenen Spur, welche mittig in den Kanälen (17) verläuft, zerlegt wird.

20. Verfahren nach Anspruch 19, **dadurch gekennzeichnet, dass** die Kanäle (17) mittels Sägen, Sandstrahlen oder Ultraschallschwingläppen des Coversubstrates (6) entlang der Gräben (9) freigelegt werden.

21. Verfahren nach Anspruch 19, **dadurch gekennzeichnet, dass** das Trägersubstrat (1) mittels Sägen getrennt wird.

22. Elektronisches Bauelement, herstellbar mit einem Verfahren nach einem der vorhergehenden Ansprüche, umfassend ein Verbund aus einem Trägersubstrat (1) und einem Coversubstrat (6), wobei auf dem Trägersubstrat (1) zumindest ein Funktionselement (3) und zumindest ein mit dem Funktionselement (3) kontaktiertes Bondelement (4) angeordnet ist, das Coversubstrat (6) ein mikrostrukturiertes Glas ist, welches auf dem Trägersubstrat (1) angeordnet ist und über dem Funktionselement (3) eine Kavität (11) bildet und die Bondelemente (4) sich außerhalb der Kavität (11) befinden,
**dadurch gekennzeichnet, dass** das Coversubstrat (6) eine ebene Glasscheibe mit einem aufgedampften Mikrorahmen (7) aus Glas ist,
wobei zumindest eine Seitenfläche des Coversubstrats (6) zumindest einen ersten Abschnitt (26) und einen zweiten Abschnitt (27) aufweist und der zumindest erste Abschnitt (26) und der zweite Abschnitt (27) eine unterschiedliche Oberflächenbeschaffenheit aufweisen,
wobei die Höhe des ersten Abschnitts (26) im Wesentlichen der Tiefe einer Makrostruktur (9) auf der Oberseite des Coversubstrates entspricht und der erste Abschnitt (26) nach oben hin in die Oberseite (F3) des Coversubstrates (6) und nach unten hin in den zweiten Abschnitt (27) übergeht und
der zweite Abschnitt (27) an seiner unteren Seite in die Unterseite (F2) des Coversubstrates (6) mündet und seine Höhe im wesentlichen der um die Tiefe der Makrostruktur reduzierten Höhe des Coversubstrates (6) im Bereich der Makrostruktur entspricht und
die Oberfläche des ersten Abschnitts (26) eine geringere Rauheit aufweist als die des zweiten Abschnitts (27).

23. Elektronisches Bauelement nach Anspruch 22, **dadurch gekennzeichnet, dass** das Trägersubstrat (1) Silizium umfasst.

24. Elektronisches Bauelement nach einem der vorhergehenden Ansprüche 22 oder 23, **dadurch gekennzeichnet, dass** die Funktionselemente (3) aktiven Halbleiter-Funktionselemente (3) umfassen.

25. Elektronisches Bauelement nach einem der vorhergehenden Ansprüche 22 oder 23, **dadurch gekennzeichnet, dass** die Funktionselemente (3) sensorisch aktive Funktionselemente (3) umfassen.

26. Elektronisches Bauelement nach einem der vorhergehenden Ansprüche 22 oder 23, **dadurch gekennzeichnet, dass** die Funktionselemente (3) optisch aktive Funktionselemente (3) umfassen.

27. Elektronisches Bauelement nach einem der Ansprüche 22 bis 26, **dadurch gekennzeichnet, dass** die Glasscheibe eine Dicke von 500 bis 1000 µm aufweist, die Rahmenstege des Mikrorahmens (7) eine Breite von 1 bis 500 µm, vorzugsweise von 80 bis 100 µm und eine Höhe von 1 bis 1000 µm, vorzugsweise von 3 bis 10 µm aufweisen.

28. Elektronisches Bauelement nach einem der vorhergehenden Ansprüche 22 bis 27, **dadurch gekennzeichnet, dass** die Bondelemente (4) wire-bondbare Bondpads umfassen.

29. Elektronisches Bauelement nach einem der vorhergehenden Ansprüche 22 bis 27, **dadurch gekennzeichnet, dass** die Bondelemente (4) lötbare Bondpads umfassen.

30. Elektronisches Bauelement nach einem der vorhergehenden Ansprüche 22 bis 29, **dadurch gekennzeichnet, dass** die Bondelemente (4) aus Au, Al, TiCu, AlSiCu oder AlSiTi bestehen.

31. Elektronisches Bauelement nach einem der vorhergehenden Ansprüche 22 bis 30, **dadurch gekennzeichnet, dass** auf der Unterseite des Trägersubstrates (1) ein wärmeableitendes Basissubstrat (21) angeordnet ist.

32. Elektronisches Bauelement nach Anspruch 31, **dadurch gekennzeichnet, dass** zwischen Trägersubstrat (1) und Basissubstrat eine Kleb- oder Lötverbindung (20) besteht.

33. Elektronisches Bauelement nach Anspruch 31 oder 32, **dadurch gekennzeichnet, dass** das Basisubstrat (21) Silizium umfasst.

34. Elektronisches Bauelement nach Anspruch 29, **dadurch gekennzeichnet, dass** auf den Bondpads (4) Lotbumps (22) aufgebracht sind, welche das Trägersubstrat (1) mit Bondpads (4) der Unterseite eines mit einer Öffnung für das gehäuste Funktionselement (3) versehenen Basissubstrats (23) verbinden.

35. Optische Baugruppe umfassend
ein Basissubstrat (23) mit einer Öffnung und unterseitigen Bondpads (4),
ein optisches Bauteil (25), welches oberhalb der Öffnung angeordnet und mit dem Basissubstrat (23) verbunden ist und ein gehäustes elektronischen Bauelement (15) gemäß Anspruch 22, welches zumindest ein optisch sensitives Funktionselement (3) und definiert angeordnete lötbare Bondpads (4) aufweist und welches unterhalb der Öffnung angeordnet und mit dem Basissubstrat (23) verbunden ist, wobei die Verbindung zwischen Basissubstrat (23) und elektronischen Bauelement (15) eine durch aufgeschmolzene Lotbumps (22) zwischen Bondpads (4) hergestellte, feinzentrierte Verbindung ist.

36. Optische Baugruppe nach Anspruch 35, **dadurch gekennzeichnet, dass** das optische Bauteil (25) eine Linse ist.

37. Optische Baugruppe nach Anspruch 35, **gekennzeichnet durch** deren Verwendung in einer digitalen Kamera.

38. Verbundsubstrat zur Herstellung von gehäusten elektronischen Bauelementen (15) umfassend
- ein Trägersubstrat (1) und ein Coversubstrat (6), welche miteinander verbunden sind,
- auf dem Trägersubstrat (1) innerhalb vorgegebener Rasterflächen (2) aufgebrachte Funktionselemente (3),
- auf dem Trägersubstrat (1) innerhalb vorgegebener Rasterbänder (8), welche zwischen den Rasterflächen (2) verlaufen, aufgebrachte Bondelemente (4),
- zumindest eine auf der Unterseite des Coversubstrates (6) und/oder der Oberseite des Trägersubstrates (1) angeordnete Mikrorahmenstruktur mit aufgedampften Mikrorahmen (7) aus Glas ist, wobei Kavitäten (11) gemäß der Rasterflächen (2) und Kanäle (17) gemäß der Rasterbänder (8) gebildet sind und zumindest ein Funktionselement (3) innerhalb einer Kavität (11) angeordnet ist und
- zumindest eine auf der Oberseite des Coversubstrates (6) durch Abtragen von Oberflächenbereichen eingebrachte Makrostruktur, wobei Gräben (9,18) gemäß der Rasterbänder (8) des Trägersubstrates (1) erzeugt sind.

39. Verbundsubstrat nach vorstehendem Anspruch **dadurch gekennzeichnet, dass** das Coversubstrat (6) eine vorzugsweise ebene Glas-, Halbleiter-, Kunststoff-, Keramik- und/oder Metallscheibe umfasst, welche insbesondere eine Dicke von 500 bis 1000 µm besitzt.

40. Verbundsubstrat nach einem der vorstehenden Ansprüche 38 oder 39 **dadurch gekennzeichnet, dass** die Rahmenstege der Mikrorahmenstruktur (7) eine Breite von 1 bis 500 µm, vorzugsweise von 80 bis 100 µm haben.

41. Verbundsubstrat nach einem der vorstehenden Ansprüche 38 bis 40 **dadurch gekennzeichnet, dass** die Rahmenstege der Mikrorahmenstruktur (7) eine Höhe von 1 bis 1000 µm, vorzugsweise von 3 bis 10 µm haben.

42. Verbundsubstrat nach einem der vorstehenden Ansprüche 38 bis 41 **dadurch gekennzeichnet, dass** die Gräben (9,18) der Makrostruktur eine Breite von 5 bis 1000 µm, vorzugsweise von 200 bis 500 µm aufweisen.

43. Verbundsubstrat nach einem der vorstehenden Ansprüche 38 bis 42 **dadurch gekennzeichnet, dass** im Bereich der Gräben (9,18) der Makrostruktur die Dicke des Coversubstrates (6) um 10 bis 80 % reduziert ist.

44. Verbundsubstrat nach einem der vorstehenden Ansprüche 38 bis 43 **dadurch gekennzeichnet, dass** die Funktionselemente (3) aktive Halbleiter-Funktionselemente (3), sensorisch aktive Funktionselemente (3) und/oder optisch aktive Funktionselemente (3) umfassen.

45. Verbundsubstrat nach einem der vorstehenden Ansprüche 38 bis 44 **dadurch gekennzeichnet, dass** auf der Unterseite des Trägersubstrates (1) zumindest ein wärmeableitendes Basissubstrat (21) angeordnet ist.

## Claims

1. Method for the production of packaged electronic components (15) having an integrated functional element (3), comprising the steps of:
a) providing a carrier substrate (1) and a cover substrate (6),
b) fitting the functional elements (3) to the carrier substrate (1) within predetermined grid areas (2),
c) fitting bonding elements (4) to the carrier substrate (1) within predetermined grid strips (8) which run between the grid areas (2), with connecting contacts (5) being produced between the functional elements (3) and the bonding elements (4),
d) fitting a microframe structure (7) composed of glass by vapour deposition to the lower face of the cover substrate (6) and/or to the upper face of the carrier substrate (1), with cavities (11) being produced corresponding to the grid areas (2), and with channels (17) being produced corresponding to the grid strips (8),
e) introducing a macrostructure at least on the upper face of the cover substrate (6) by removal of surface areas, with trenches (9) being produced corresponding to the grid strips (8) on the carrier substrate (1),
f) joining together the carrier and cover substrates (1, 6) to form a composite substrate, with the functional elements (3) being packaged, and
g) splitting the composite substrate along a predetermined track within the grid strips (8), with the composite substrate being broken up into individual components (15), and with the bonding elements (4) of the separated components (15) being exposed at the same time.

2. Method as claimed in claim 1, **characterised in that** a semiconductor wafer is provided as the carrier substrate (1).

3. Method as claimed in claim 2, **characterised in that** a semiconductor wafer composed of silicon is provided as the carrier substrate (1).

4. Method as claimed in any one of the preceding claims, **characterised in that** the fitting of the functional elements (3) comprises the fitting of active semiconductor functional elements (3).

5. Method as claimed in any one of the preceding claims, **characterised in that** the fitting of the functional elements (3) comprises the fitting of active-sensor functional elements (3).

6. Method as claimed in any one of the preceding claims, **characterised in that** the fitting of the functional elements (3) comprises the fitting of optically active functional elements (3).

7. Method as claimed in any one of the preceding claims, **characterised in that** a flat semiconductor, plastic, ceramic or metallic wafer with a thickness of 500 to 1000 µm is provided as the cover substrate (6).

8. Method as claimed in any one of the preceding claims, in particular as claimed in claim 6, **characterised in that** a flat glass pane with a thickness of 500 to 1000 µm is provided as the cover substrate (6).

9. Method as claimed in any one of the preceding claims, **characterised in that** the frame webs of the microframe structure (7) are fitted with a width of 1 to 500 µm, preferably 80 to 100 µm, and/or with a height of 1 to 1000 µm, preferably 3 to 10 µm.

10. Method as claimed in any one of the preceding claims, **characterised in that** the fitting of the microframe structure (7) comprises the steps of:
- fitting a mask which provides a negative image of the microframe structure (7),
- vapour-depositing a glass layer, and
- removing the mask by means of a lift-off technique.

11. Method as claimed in any one of the preceding claims, **characterised in that** the trenches (9) in the macrostructure are introduced with a width of 5 to 1000 µm, preferably 200 to 500 µm.

12. Method as claimed in any one of the preceding claims, **characterised in that** the thickness of the cover substrate (6) is reduced by 10 to 80% in the area of the trenches (9) in the macrostructure.

13. Method as claimed in any one of the preceding claims, **characterised in that** the trenches (9) in the macrostructure are introduced on the upper face and lower face of the cover substrate (6).

14. Method as claimed in any one of claims 11 to 12, **characterised in that** a macrostructure is introduced by removal of surface areas of the cover substrate (6) by means of etching, sandblasting or ultrasound oscillation lapping.

15. Method as claimed in any one of the preceding claims, **characterised in that** the microframe structure (7) is fitted to the lower face of the cover substrate (6).

16. Method as claimed in claim 15, **characterised in that** an adhesive layer, preferably composed of epoxy resin is applied to the microframe structure (7), and the upper face of the carrier substrate (1) is adhesively bonded to the microframe structure (7) on the lower face of the cover substrate (6), to form a composite substrate.

17. Method as claimed in any one of the preceding claims, **characterised in that** the microframe structure (7) is fitted to the upper face of the carrier substrate (1).

18. Method as claimed in claim 17, **characterised in that** the microframe structure (7) on the upper face of the carrier substrate (1) is joined to the lower face of the cover substrate (6) by means of anodic bonding, fusion bonding, sol-gel bonding, low-temperature bonding, soldering or adhesive bonding to form a composite substrate.

19. Method as claimed in any one of the preceding claims, **characterised in that** the composite substrate is broken up by exposure of the channels (17) along the trenches (9) in the cover substrate (6), and by splitting the carrier substrate (1) along the predetermined track, which runs centrally in the channels (17).

20. Method as claimed in claim 19, **characterised in that** the channels (17) are exposed by sawing, sandblasting or ultrasound oscillation lapping of the cover substrate (6) along the trenches (9).

21. Method as claimed in claim 19, **characterised in that** the carrier substrate (1) is split by sawing.

22. Electronic component which can be produced by a method as claimed in any one of the preceding claims and comprises a composite composed of a carrier substrate (1) and a cover substrate (6), wherein
at least one functional element (3) and at least one bonding element (4), which is contacted by the functional element (3), is arranged on the carrier substrate (1), the cover substrate (6) is a microstructured glass which is arranged on the carrier substrate (1) and forms a cavity (11) over the functional element (3),
and the bonding elements (4) are located outside the cavity (11),
**characterised in that** the cover substrate (6) is a flat glass pane with a vapour-deposited microframe (7) composed of glass,
wherein at least one side surface of the cover substrate (6) comprises at least one first section (26) and one second section (27) and the at least one first section (26) and the second section (27) have a different surface configuration,
wherein the height of the first section (26) substantially corresponds to the depth of a macrostructure (9) on the top face of the cover substrate and the first section (26) merges into the top face (F3) of the cover substrate (6) upwards and merges into the second section (27) downwards, and
the second section (27) opens on its lower face into the lower face (F2) of the cover substrate (6) and its height substantially corresponds to the height of the cover substrate (6), reduced by the depth of the macrostructure, in the region of the macrostructure, and
the surface of the first section (26) has less roughness than that of the second section (27).

23. Electronic component as claimed in claim 22, **characterised in that** the carrier substrate (1) comprises silicon.

24. Electronic component as claimed in any one of the preceding claims 22 or 23, **characterised in that** the functional elements (3) comprise active semiconductor functional elements (3).

25. Electronic component as claimed in any one of the preceding claims 22 or 23, **characterised in that** the functional elements (3) comprise active-sensor functional elements (3).

26. Electronic component as claimed in any one of the preceding claims 22 or 23, **characterised in that** the functional elements (3) comprise optically active functional elements (3).

27. Electronic component as claimed in any one of the preceding claims 22 to 26, **characterised in that** the glass pane has a thickness of 500 to 1000 µm and the frame webs of the microframe (7) have a width of 1 to 500 µm, preferably 80 to 100 µm, and a height of 1 to 1000 µm, preferably 3 to 10 µm.

28. Electronic component as claimed in any one of the preceding claims 22 to 27, **characterised in that** the bonding elements (4) comprise bonding pads which can be wire-bonded.

29. Electronic component as claimed in any one of the preceding claims 22 to 27, **characterised in that** the bonding elements (4) comprise bonding pads which can be soldered.

30. Electronic component as claimed in any one of the preceding claims 22 to 29, **characterised in that** the bonding elements (4) are composed of Au, Al, TiCu, AlSiCu or AlSiTi.

31. Electronic component as claimed in any one of the preceding claims 22 to 30, **characterised in that** a heat-dissipating base substrate (21) is arranged on the lower face of the carrier substrate (1).

32. Electronic component as claimed in claim 31, **characterised in that** an adhesive or solder connection (20) is provided between the carrier substrate (1) and the base substrate.

33. Electronic component as claimed in claim 31 or 32, **characterised in that** the base substrate (21) comprises silicon.

34. Electronic component as claimed in claim 29, **characterised in that** solder bumps (22) are applied to the bonding pads (4) and connect the carrier substrate (1) to bonding pads (4) on the lower face of a base substrate (23) which is provided with an opening for the packaged functional element (3).

35. Optical assembly comprising
a base substrate (23) with an opening and lower-face bonding pads (4),
an optical part (25) which is arranged above the opening and is connected to the base substrate (23), and
a packaged electronic component (15) as claimed in claim 22 which has at least one optically sensitive functional element (3) and bonding pads (4) which are arranged in a defined manner and can be soldered, and which electronic component is arranged under the opening and is connected to the base substrate (23),
with the connection between the base substrate (23) and the electronic component (15) being a finely-centred connection which is produced by melted-on solder bumps (22) between bonding pads (4).

36. Optical assembly as claimed in claim 35, **characterised in that** the optical part (25) is a lens.

37. Optical assembly as claimed in claim 35, **characterised by** the assembly being used in a digital camera.

38. Composite substrate for production of packaged electronic components (15), comprising
- a carrier substrate (1) and a cover substrate (6) which are connected to one another,
- functional elements (3) which are fitted to the carrier substrate (1) within predetermined grid areas (2),
- bonding elements (4) which are fitted to the carrier substrate (1) within predetermined grid strips (8), which run between the grid areas (2),
- at least one microframe structure, with vapour-deposited microframes (7) composed of glass, which structure is arranged on the lower face of the cover substrate (6) and/or on the upper face of the carrier substrate (1), with cavities (11) being formed corresponding to the grid areas (2) and with channels (17) being formed corresponding to the grid strips (8), and with at least one functional element (3) being arranged within a cavity (11), and
- at least one macrostructure, which is introduced on the upper face of the cover substrate (6) by removal of surface areas, with trenches (9, 18) being produced corresponding to the grid strips (8) of the carrier substrate (1).

39. Composite substrate as claimed in the preceding claim, **characterised in that** the cover substrate (6) comprises a preferably flat glass, semiconductor, plastic, ceramic and/or metal pane/wafer which has in particular a thickness of 500 to 1000 µm.

40. Composite substrate as claimed in any one of the preceding claims 38 or 39, **characterised in that** the frame webs of the microframe structure (7) have a width of 1 to 500 µm, preferably 80 to 100 µm.

41. Composite substrate as claimed in any one of the preceding claims 38 to 40, **characterised in that** the frame webs of the microframe structure (7) have a height of 1 to 1000 µm, preferably 3 to 10 µm.

42. Composite substrate as claimed in any one of the preceding claims 38 to 41, **characterised in that** the trenches (9, 18) in the macrostructure have a width of 5 to 1000 µm, preferably 200 to 500 µm.

43. Composite substrate as claimed in any one of the preceding claims 38 to 42, **characterised in that** the thickness of the cover substrate (6) is reduced by 10 to 80% in the area of the trenches (9, 18) in the macrostructure.

44. Composite substrate as claimed in any one of the preceding claims 38 to 43, **characterised in that** the functional elements (3) comprise active semiconductor functional elements (3), active-sensor functional elements (3), and/or optically active functional elements (3).

45. Composite substrate as claimed in any one of the preceding claims 38 to 44, **characterised in that** at least one heat-dissipating base substrate (21) is arranged on the lower face of the carrier substrate (1).

## Revendications

1. Procédé de fabrication de composants électroniques encapsulés (15) avec un élément fonctionnel (3) intégré, comprenant les étapes suivantes :
a) préparation d'un substrat de support (1) et d'un substrat de couverture (6),
b) application des éléments fonctionnels (3) sur le substrat de support (1) à l'intérieur de surfaces tramées (2) définies,
c) application d'éléments de liaison (4) sur le substrat de support (1) à l'intérieur de bandes tramées (8) s'étendant entre les surfaces tramées (2) et réalisation des contacts de connexion (5) entre les éléments fonctionnels (3) et les éléments de liaison (4),
d) application d'une structure de micro-cadre (7) en verre par dépôt en phase vapeur sur la face inférieure du substrat de couverture (6) et/ou sur la face supérieure du substrat de support (1), des cavités (11) étant produites en correspondance des surfaces tramées (2) et des canaux (17) en correspondance des bandes tramées (8),
e) formation d'une macrostructure au moins sur la face supérieure du substrat de couverture (6) par érosion de zones de surface, des fossés (9) étant produits en correspondance des bandes tramées (8) du substrat de support (1),
f) assemblage du substrat de support et du substrat de couverture (1, 6) pour former un substrat composite, les éléments fonctionnels (3) étant encapsulés, et
g) détachement du substrat composite le long d'un tracé défini à l'intérieur des bandes tramées (8), le substrat composite étant fractionné en composants (15) individuels et les éléments de liaison (4) des différents composants (15) étant simultanément dégagés.

2. Procédé selon la revendication 1, **caractérisé en ce qu'**une tranche de semi-conducteur est préparée comme substrat de support (1).

3. Procédé selon la revendication 2, **caractérisé en ce qu'**une tranche de semi-conducteur en silicium est préparée comme substrat de support (1).

4. Procédé selon l'une des revendications précédentes, **caractérisé en ce que** l'application des éléments fonctionnels (3) comprend l'application d'éléments fonctionnels semi-conducteurs actifs (3).

5. Procédé selon l'une des revendications précédentes, **caractérisé en ce que** l'application des éléments fonctionnels (3) comprend l'application d'éléments fonctionnels capteurs actifs (3).

6. Procédé selon l'une des revendications précédentes, **caractérisé en ce que** l'application des éléments fonctionnels (3) comprend l'application d'éléments fonctionnels optiques actifs (3).

7. Procédé selon l'une des revendications précédentes, **caractérisé en ce qu'**une rondelle plane en semi-conducteur, en matière synthétique, en céramique ou en métal ayant une épaisseur comprise entre 500 et 1000 µm est préparée comme substrat de couverture (6).

8. Procédé selon l'une des revendications précédentes, en particulier selon la revendication 6, caractérisé en ce en ce qu'une rondelle de verre plane ayant une épaisseur comprise entre 500 et 1000 µm est préparée comme substrat de couverture (6).

9. Procédé selon l'une des revendications précédentes, **caractérisé en ce que** les barres de cadre de la structure de micro-cadre (7) sont appliquées avec une largeur comprise entre 1 et 500 µm, préférentiellement entre 80 et 100 µm, et/ou avec une hauteur comprise entre 1 et 1000 µm, préférentiellement entre 3 et 10 µm.

10. Procédé selon l'une des revendications précédentes, **caractérisé en ce que** l'application de la structure de micro-cadre (7) comprend les étapes suivantes :
- application d'un masque représentant la structure de micro-cadre (7) en négatif,
- dépôt en phase vapeur d'une couche de verre, et
- retrait du masque par procédé de décollage.

11. Procédé selon l'une des revendications précédentes, **caractérisé en ce que** les fossés (9) de la macrostructure sont appliqués avec une largeur comprise entre 5 et 1000 µm, préférentiellement entre 200 et 500 µm.

12. Procédé selon l'une des revendications précédentes, **caractérisé en ce qu'**au niveau des fossés (9) de la macrostructure, l'épaisseur du substrat de couverture (6) est réduite de 10 à 80 %.

13. Procédé selon l'une des revendications précédentes, **caractérisé en ce que** les fossés (9) de la macrostructure sont formés sur la face supérieure et la face inférieure du substrat de couverture (6).

14. Procédé selon l'une des revendications 11 et 12, **caractérisé en ce que** la formation d'une macrostructure par érosion de zones de surface du substrat de couverture (6) est effectuée par attaque chimique, sablage ou par rodage à ultrasons.

15. Procédé selon l'une des revendications précédentes, **caractérisé en ce que** la structure de micro-cadre (7) est appliquée sur la face inférieure du substrat de couverture (6).

16. Procédé selon la revendication 15, **caractérisé en ce qu'**une couche de colle est appliquée sur la structure de micro-cadre (7), préférentiellement en résine époxy, et **en ce que** la face supérieure du substrat de support (1) est collée à la structure de micro-cadre (7) de la face inférieure du substrat de couverture (6) pour former un substrat composite.

17. Procédé selon l'une des revendications précédentes, **caractérisé en ce que** la structure de micro-cadre (7) est appliquée sur la face supérieure du substrat de support (1).

18. Procédé selon la revendication 17, **caractérisé en ce que** la structure de micro-cadre (7) de la face supérieure du substrat de support (1) et la face inférieure du substrat de couverture (6) sont assemblées par liaison anodique, liaison par fusion, liaison sol-gel, liaison à basse température, brasage ou collage pour former un substrat composite.

19. Procédé selon l'une des revendications précédentes, **caractérisé en ce que** le substrat composite est fractionné par dégagement des canaux (17) le long des fossés (9) du substrat de couverture (6) et par détachement du substrat de support (1) le long du tracé défini qui s'étend au centre des canaux (17).

20. Procédé selon la revendication 19, **caractérisé en ce que** les canaux (17) sont dégagés par sciage, sablage ou rodage ou rodage à ultrasons du substrat de couverture (6) le long des fossés (9).

21. Procédé selon la revendication 19, **caractérisé en ce que** le substrat de support (1) est détaché par sciage.

22. Composant électronique, pouvant être fabriqué au moyen d'un procédé selon l'une des revendications précédentes, comprenant un composite formé d'un substrat de support (1) et d'un substrat de couverture (6),
au moins un élément fonctionnel (3) et au moins un élément de liaison (4) mis en contact avec l'élément fonctionnel (3) étant disposés sur le substrat de support (1),
le substrat de couverture (6) étant un verre microstructuré disposé sur le substrat de support (1) et formant une cavité (11) au moyen de l'élément fonctionnel (3), et les éléments de liaison (4) se trouvant à l'extérieur de la cavité (11),
**caractérisé en ce que** le substrat de couverture (6) est une rondelle en verre plane avec un micro-cadre (7) en verre déposé en phase vapeur,
au moins une surface latérale du substrat de couverture (6) comportant au moins une première partie (26) et une deuxième partie (27), et la au moins une première partie (26) et la deuxième partie (27) présentant des caractéristiques de surface différentes,
la hauteur de la première partie (26) correspondant sensiblement à la profondeur d'une macrostructure (9) sur la face supérieure du substrat de couverture, et la première partie (26) se prolongeant vers le haut par la face supérieure (F3) du substrat de couverture (6) et vers le bas par la deuxième partie (27), et
la deuxième partie (27) aboutissant vers le bas à la face inférieure (F2) du substrat de couverture (6), et sa hauteur correspondant sensiblement à la hauteur du substrat de couverture (6) diminuée de la profondeur de la macrostructure au niveau de la macrostructure, et
la surface de la première partie (26) présentant une moindre rugosité que celle de la deuxième partie (27).

23. Composant électronique selon la revendication 22, **caractérisé en ce que** le substrat de support (1) comprend du silicium.

24. Composant électronique selon la revendication 22 ou 23, **caractérisé en ce que** les éléments fonctionnels (3) comprennent des éléments fonctionnels semi-conducteurs actifs (3).

25. Composant électronique selon la revendication 22 ou 23, **caractérisé en ce que** les éléments fonctionnels (3) comprennent des éléments fonctionnels capteurs actifs (3).

26. Composant électronique selon la revendication 22 ou 23, **caractérisé en ce que** les éléments fonctionnels (3) comprennent des éléments fonctionnels optiques actifs (3).

27. Composant électronique selon l'une des revendications 22 à 26, **caractérisé en ce que** la rondelle en verre présente une épaisseur comprise entre 500 et 1000 µm, les barres de cadre du micro-cadre (7) une largeur comprise entre 1 et 500 µm, préférentiellement entre 80 et 100 µm et une hauteur comprise entre 1 et 1000 µm, préférentiellement entre 3 et 10 µm.

28. Composant électronique selon l'une des revendications 22 à 27, **caractérisé en ce que** les éléments de liaison (4) comprennent des plots de connexion micro-câblables.

29. Composant électronique selon l'une des revendications 22 à 27, **caractérisé en ce que** les éléments de liaison (4) comprennent des plots de connexion brasables.

30. Composant électronique selon l'une des revendications 22 à 29, **caractérisé en ce que** les éléments de liaison (4) sont en Au, Al, TiCu, AlSiCu ou AlSiTi.

31. Composant électronique selon l'une des revendications 22 à 30, **caractérisé en ce qu'**un substrat de base (21) dissipateur de chaleur est disposé sur la face inférieure du substrat de support (1).

32. Composant électronique selon la revendication 31, **caractérisé en ce qu'**une connexion par collage ou brasage (20) est présentée entre le substrat de support (1) et le substrat de base.

33. Composant électronique selon la revendication 31 ou 32, **caractérisé en ce que** le substrat de base (21) comprend du silicium.

34. Composant électronique selon la revendication 29, **caractérisé en ce que** des bosses brasées (22) sont appliquées sur les plots de connexion (4), lesquelles relient le substrat de support (1) aux plots de connexion (4) de la face inférieure d'un substrat de base (23) pourvu d'une ouverture pour l'élément fonctionnel (3) encapsulé.

35. Groupe optique de composants, comprenant :
un substrat de base (23) avec une ouverture et des plots de connexion (4) sur sa face inférieure,
un composant optique (25) disposé au-dessus de l'ouverture et relié au substrat de base (23), et
un composant électronique encapsulé (15) selon la revendication 22, qui comporte au moins un élément fonctionnel (3) optiquement sensible et des plots de connexion (4) brasables disposés de manière définie, et qui est disposé sous l'ouverture et relié au substrat de base (23),
la connexion entre substrat de base (23) et composant électronique (15) étant une connexion à centrage de précision réalisée par des bosses brasées (22) appliquées entre les plots de connexion (4).

36. Groupe optique de composants selon la revendication 35, **caractérisé en ce que** le composant optique (25) est une lentille.

37. Groupe optique de composants selon la revendication 35, **caractérisé par** son utilisation dans une caméra numérique.

38. Substrat composite pour la fabrication de composants électroniques encapsulés (15), comprenant :
- un substrat de support (1) et un substrat de couverture (6) raccordés l'un à l'autre,
- des éléments fonctionnels (3) appliqués sur le substrat de support (1) à l'intérieur de surfaces tramées (2) définies,
- des éléments de liaison (4) appliqués sur le substrat de support (1) à l'intérieur de bandes tramées (8) définies qui s'étendent entre les surfaces tramées (2),
- au moins une structure de micro-cadre disposée sur la face inférieure du substrat de couverture (6) et/ou la face supérieure du substrat de support (1), avec des micro-cadres (7) en verre déposés en phase vapeur, des cavités (11) étant formées en correspondance des surfaces tramées (2) et des canaux (17) en correspondance des bandes tramées (8), et au moins un élément fonctionnel (3) étant disposé à l'intérieur d'une cavité (11), et
- au moins une macrostructure formée par érosion de zones de surface sur la face supérieure du substrat de couverture (6), des fossés (9, 18) étant produits en correspondance des bandes tramées (8) du substrat de support (1).

39. Substrat composite selon la revendication précédente, **caractérisé en ce que** le substrat de couverture (6) comprend une rondelle préférentiellement plane en verre, semi-conducteur, matière synthétique, céramique et/ou en métal ayant en particulier une épaisseur comprise entre 500 et 1000 µm.

40. substrat composite selon l'une des revendications 38 ou 39, **caractérisé en ce que** les barres de cadre de la structure de micro-cadre (7) ont une largeur comprise entre 1 et 500 µm, préférentiellement entre 80 et 100 µm.

41. Substrat composite selon l'une des revendications 38 à 40, **caractérisé en ce que** les barres de cadre de la structure de micro-cadre (7) ont une hauteur comprise entre 1 et 1000 µm, préférentiellement entre 3 et 10 µm.

42. Substrat composite selon l'une des revendications 38 à 41, **caractérisé en ce que** les fossés (9, 18) de la macrostructure ont une largeur comprise entre 5 et 1000 µm, préférentiellement entre 200 et 500 µm.

43. Substrat composite selon l'une des revendications 38 à 42, **caractérisé en ce qu'**au niveau des fossés (9, 18) de la macrostructure, l'épaisseur du substrat de couverture (6) est réduite de 10 à 80 %.

44. Substrat composite selon l'une des revendications 38 à 43, **caractérisé en ce que** les éléments fonctionnels (3) comprennent des éléments fonctionnels semi-conducteurs actifs (3), des éléments fonctionnels capteurs actifs (3) et/ou des éléments fonctionnels optiques actifs (3).

45. Substrat composite selon l'une des revendications 38 à 44, **caractérisé en ce qu'**au moins un substrat de base (21) dissipateur de chaleur est disposé sur la face inférieure du substrat de support (1).
